(19) **Europäisches Patentamt European Patent Office Office européen des brevets**

(11) **EP 4 544 749 B1**

(12) **EUROPEAN PATENT SPECIFICATION**

(45) Date of publication and mention
of the grant of the patent:
**24.06.2026 Bulletin 2026/26**

(21) Application number: **23706046.2**

(22) Date of filing: **24.02.2023**

(51) International Patent Classification (IPC):
$H04L\ 27/34^{(2006.01)}$ $H04L\ 27/36^{(2006.01)}$

(52) Cooperative Patent Classification (CPC):
**H04L 27/3488; H04L 27/361**

(86) International application number:
**PCT/EP2023/054701**

(87) International publication number:
**WO 2024/002529 (04.01.2024 Gazette 2024/01)**

(54) **CHANNEL COMPUTATION**

KANALBERECHNUNG

CALCUL DE CANAL

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **27.06.2022 EP 22181393**

(43) Date of publication of application:
**30.04.2025 Bulletin 2025/18**

(73) Proprietor: **Fischione Consulting AB
11351 Stockholm (SE)**

(72) Inventors:
• **FISCHIONE, Carlo
11351 Stockholm (SE)**
• **RAZAVIKIA, Seyedsaeed
1109 Stockholm (SE)**
• **MAIRTON BARROS DA SILVA JUNIOR, José
75266 Uppsala (SE)**

(74) Representative: **Høiberg P/S
Adelgade 12
1304 Copenhagen K (DK)**

(56) References cited:
• **GUANGXU ZHU ET AL: "Over-the-Air Computing
for 6G -- Turning Air into a Computer",
ARXIV.ORG, CORNELL UNIVERSITY LIBRARY,
201 OLIN LIBRARY CORNELL UNIVERSITY
ITHACA, NY 14853, 4 September 2020
(2020-09-04), XP081755921**
• **GUANGXU ZHU ET AL: "Over-the-Air Computing
for Wireless Data Aggregation in Massive IoT",
ARXIV.ORG, CORNELL UNIVERSITY LIBRARY,
201 OLIN LIBRARY CORNELL UNIVERSITY
ITHACA, NY 14853, 14 November 2020
(2020-11-14), XP081814101**

Processed by Luminess, 75001 PARIS (FR)

**Description**

The invention relates to a computer-implemented method, a system and a receiver for in-channel function computation.

**Background**

Communication systems are ubiquitous in modern life. They make it possible for billions of people to communicate, exchange images, voice or voice recordings and multiple types of data. Communications systems are also employed for exchange of data between humans and machines, or vice versa and between machines. In particular, communications systems are currently deployed for communication between different types of IoT (Internet of Things) devices and between said IoT devices and the cloud. Data from tens, hundreds, thousands, or even millions of IoT devices are sent to the cloud, where they are often used for training cloud-based machine learning (ML) models, are used by ML models or Artificial Intelligence algorithms (AI) to perform all kinds of computations.

Full implementation of the internet of things (IoT), will reshape our lifestyle through providing ubiquitous connectivity of almost everything. Recently, generations of wireless communications have been accompanied by a paradigm shift from human-type communications to machine-type communications. On the one hand, the number of IoT devices is predicted to reach 75 billion by 2025, much larger than that of mobile phone users. The various IoT applications based on AI or machine learning (ML) or data processing methods are set to emerge in 6G (6-th generation wireless systems), which require collecting, transmitting, and performing calculation of enormous amounts of data from many devices. Consequently, extensive connectivity needs to scale-up communication and computation resources, which means swamping the capacity of the current systems.

In a typical setup where data needs to be processed via computations (such as, but not limited to, AI and ML), a plurality of devices sends data to the computing point via one or more channels, the data is received and collected at the computing point, and operations are performed by one or more processor or computer to process the collected data. As several steps are involved, this process, which may be called the "transmit-then-compute process", takes time, computational resources, and consumes huge amount of transmission and computational power. Scaling up this process demands a new technology which is more efficient in terms of required time, computational and power resources.

Relevant prior art consists in the following:

GUANGXU ZHU ET AL: "Over-the-Air Computing for 6G -- Turning Air into a Computer", ARXIV.ORG, CORNELL UNIVERSITY LIBRARY, 201 OLIN LIBRARY CORNELL UNIVERSITY ITHACA, NY 14853, 4 September 2020 and

GUANGXU ZHU ET AL: "Over-the-Air Computing for Wireless Data Aggregation in Massive IoT", ARXIV.ORG, CORNELL UNIVERSITY LIBRARY, 201 OLIN LIBRARY CORNELL UNIVERSITY ITHACA, NY 14853, 14 November 2020

**Summary**

In the present disclosure, the term encoding is used interchangeably with the term modulation and the term decoding interchangeably with demodulation. For example, the skilled person will understand that PSK, QAM or FSK are encoding schemes or modulations.

To better support emerging compute-intensive applications, e.g., virtual reality, edge computing, edge learning, especially federated learning, over the air computation (AirComp) is a promising concept to simultaneously collect and compute data at the edge network.

The AirComp solution leverages the waveform superposition property of the multi-access channel occurring in the specific case of linear time-invariant channels to realize aggregation of data simultaneously transmitted by devices, allowing each device to access all radio resources, unlike the standard transmit-then-compute scheme. In one embodiment of the presently disclosed computer-implemented method for in-channel function computation in a digital communication system, the computation and transmission occurs simultaneously. This means that a function may be computed over the channel. Moreover, the AirComp approach integrates communication and computation steps and provides ultra-fast wireless data aggregation in IoT networks with high-spectrum efficiency. AirComp reduces the required energy of each device for transmission while it can bring high rate communication thereof by harnessing interference to help functional computation. Besides preserving the privacy and security of data, the coverage area can also be enlarged since more devices can transmit at the same time and frequency.

However, the AirComp approach is analog, it is based on a particular case of analog modulations, the case of amplitude analog modulation, and requires enforcement of analog communication systems, for example the transmitting devices and/or a receiver may need to be equipped with an analog front-end or back-end for analog modulation.

This is very unpractical as most of the device or transmitting units, such as IoT devices, are currently fully digital and may not directly implement analog modulations. AirComp is not compatible not only with digital modulations, but also with general analog modulations, such as analog modulations based on both amplitude and phase modulation. Moreover, AirComp only works for linear time-invariant communication channels, whereas cannot work for time-variant communication channels.

The object of the invention is achieved by the subject-matter of the independent claims. The dependent claims describe advantageous embodiments. The scope of protection of the invention is limited by the appended claims.

The presently disclosed methods and systems are hereby named ChannelComp, which stands for "Channel Computation".

## Description of the drawings

The invention will in the following be described with reference to the accompanying drawings. The drawings are examples of embodiments and not limiting to the presently disclosed computer-implemented method, system and receiver for in-channel function computation in a digital communication system.

Fig. 1 shows a schematic view of a flow diagram of one embodiment of the presently disclosed method.

Fig. 2 shows a schematic view of an encoding scheme constellation and decoding scheme of superpositions constellation in one embodiment of the presently disclosed method.

Fig. 3 shows a communication model of one embodiment of the presently disclosed method.

Fig. 4 shows a mathematical representation of a decoding scheme in one embodiment of the presently disclosed method.

Fig. 5 shows an embodiment of the presently disclosed digital communication system.

Fig. 6 shows a table with a counterexample to show that a symmetric function is not necessarily computable.

Fig. 7 shows an embodiment of a constellation diagram.

Fig. 8 shows a counterexample of a non-computable function with more or equal constellation points of the superpositions than the combination or function of input transmitted digital data.

Fig. 9 shows an embodiment of the space of digital data, the constellation points of the superpositions, and the values of a function or combination of digital data.

Fig. 10 shows one embodiment of a MIMO setup for decreasing distortion, according to one embodiment of the present disclosure. A k user may use $N_t$ antennas.

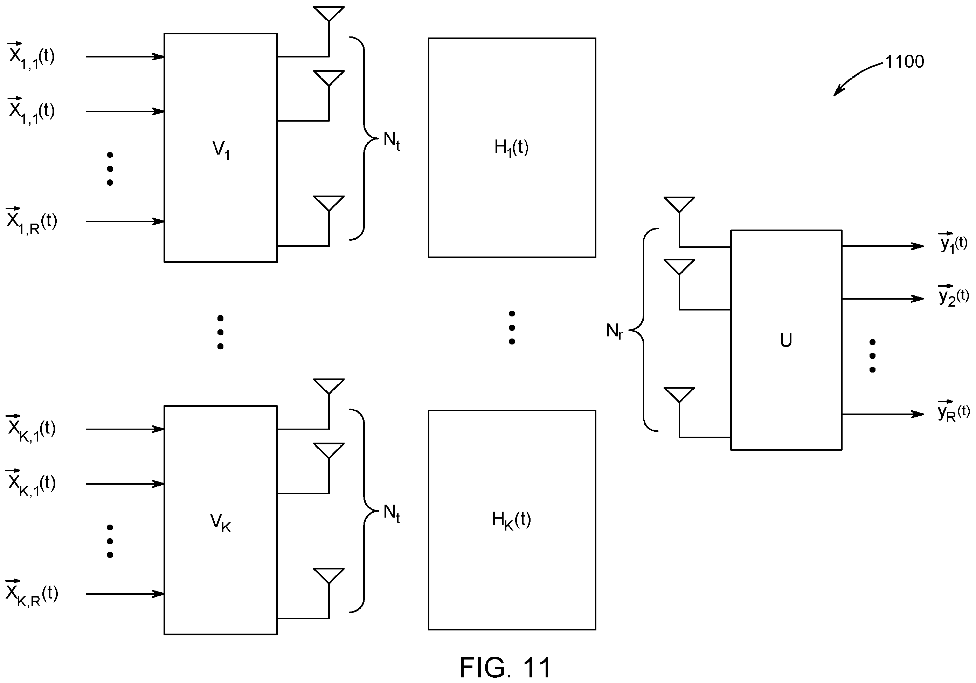

Fig. 11 shows one embodiment of a Rate enhancement MIMO setup.

Fig. 12 shows one embodiment of a broadband ChannelComp transceiver and transmitter architecture, according to the present disclosure.

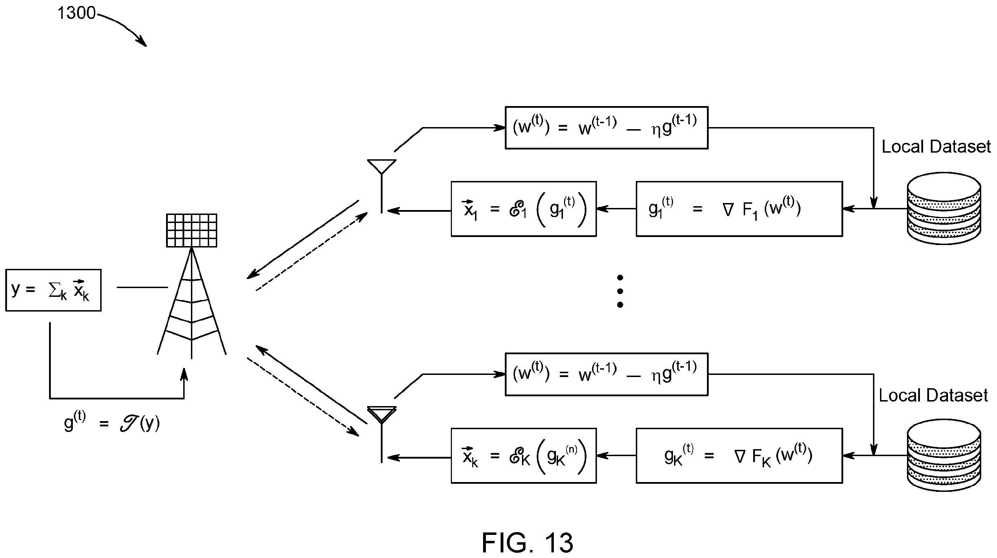

Fig. 13 shows a diagram of one embodiment of federated learning using the presently disclosed ChannelComp method and/or system.

Fig. 14 shows an overview of application of the presently disclosed computer-implemented method for in-channel function computation.

## Detailed description

*Method*

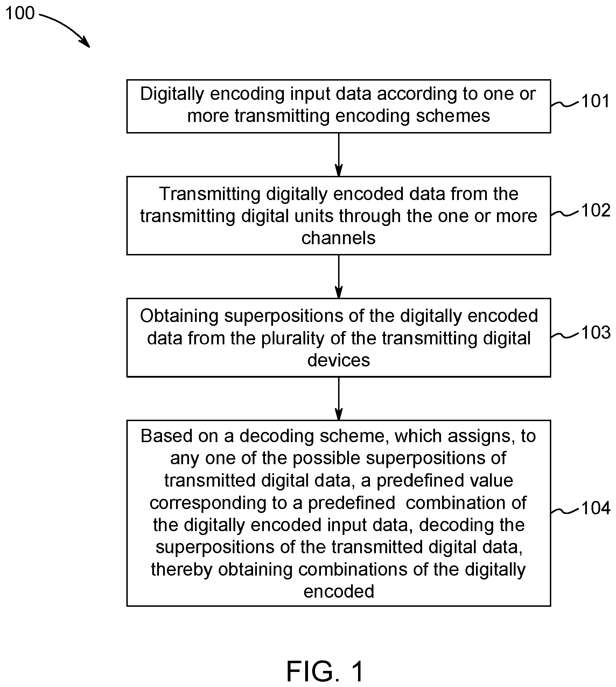

Fig. 1 shows a flow diagram of one embodiment of the presently disclosed method (100).

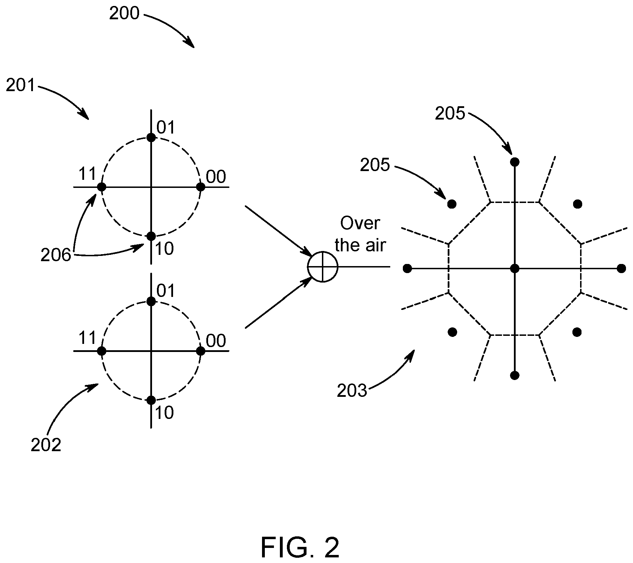

Fig. 2 shows a schematic view of an encoding scheme constellation (201, 202) and a constellation of superpositions (203) in one embodiment of the presently disclosed method (200).

In one embodiment of the present disclosure, shown in Fig. 2, the transmitting devices, or transmitting digital units, may use a QPSK encoding scheme for 2 Bit quantization. In this embodiment the users or transmitting digital units may be 2. A first transmitting digital unit may be transmitting with a first QPSK encoding scheme (201) and a second user or transmitting digital unit may be transmitting with a second QPSK encoding scheme (202). In the embodiment shown if Fig. 2 there are only two users or transmitting units but the presently disclosed method is general and may be applied to an arbitrary number of transmitting units, such as more than 10, preferably more than 100, more preferably more than 1000, even more preferably more than 10000, most preferably more than 100000. In the embodiment shown in Fig. 2 the encoding scheme used by the transmitting digital units is QPSK, but the presently disclosed method is general and may be applied to any arbitrary or standard analog or digital encoding scheme, with the only assumption that a receiver and a decoding scheme is aware of the used encoding schemes for transmission. In the embodiment of Fig. 2 the constellation or representation of digitally converted data in the amplitude-phase plane is limited to 4 points (206). The arrow (206) is pointing to only 2 of the constellation points in the encoding scheme of the first transmitting unit, but it is meant to represent all the 4 points in the constellation of the encoding scheme for the first unit. The encoding scheme of the first and second transmitting digital unit is, in the embodiment shown in Fig. 2, a QPSK encoding scheme, comprising 4 constellation points representing the values, in bit quantization, of 00, 01, 10, 11. In the embodiment shown in Fig. 2 the QPSK encoded transmitted digital data may interfere in the channel forming a number of superpositions (205) arranged in a constellation (203) of possible superpositions in the amplitude-phase plane. The constellation (203) of superpositions may comprise a larger number of points than the constellation of transmitted digital data. Each point in the superposition constellation (203) may be assigned, in a decoding scheme, to a predefined value corresponding to a combination of the input transmitted data. This way, by decoding the points in the superpositions constellation (203) it is possible to obtain a value corresponding to a combination of input transmitted data. In the presently disclosed method, the actual computation of combinations of transmitted data is performed in the channel by means of the formation of superpositions and by means of a decoding scheme configured to give a meaning of said superpositions and to decode them to meaningful values corresponding to combinations, or functions, of transmitted digital data. The receiver can directly decode the superpositions as values corresponding to combinations of transmitted data. Such a combination, may be, for example, a weighted sum, which is beneficial for in-channel computation of a federated average of machine learning models. The combination may, otherwise, be any mathematical function of data.

In the embodiment of Fig. 2 the channel may be over the air, but any other time-invariant or time-variant channel may be used in the presently disclosed method, such as an electric channel, an optical channel, a quantum channel, an acoustic channels, a light channel, a molecular channel, or any medium capable to carry analog or digital modulated signals.

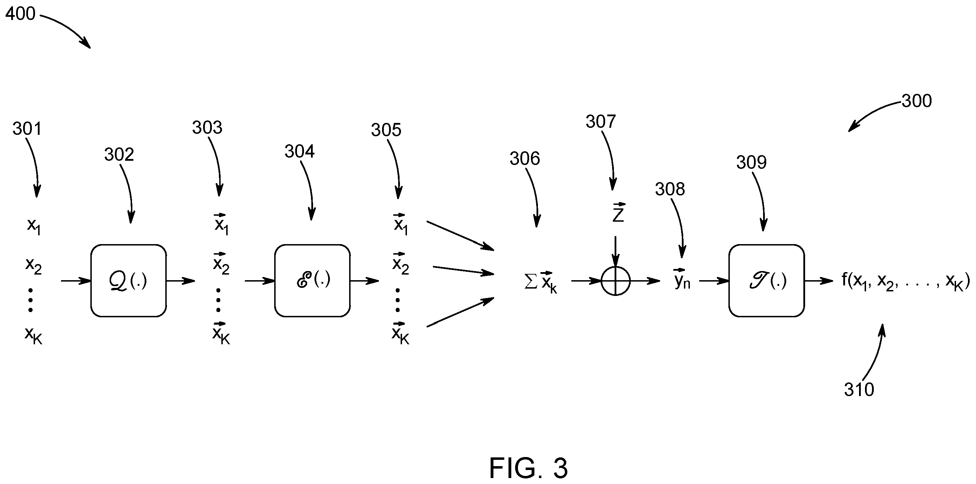

Fig. 3 shows one embodiment (300) of the presently disclosed method. In this embodiment true values (301) of input data from K users are quantized by a quantification module (301) and encoded or modulated by encoder (304) into transmitted digital data. In the time-invariant or time-variant channel the transmitted digital data with finite constellation points interfere, for example according to the interference sum (306), are combined with noise effect (307), such as Gaussian noise, and superpositions (308) are obtained in the time-invariant or time-variant channel, ready to be decoded by a receiver using a function (309) that assigns to each superposition (308) a predefined value (310) corresponding to a combination of transmitted digital data. In one embodiment of the present disclosure, the function that assigns to each superposition a predefined value corresponding to a combination of transmitted data is computable, that is it is such that to each superposition a unique combination of transmitted data is assigned.

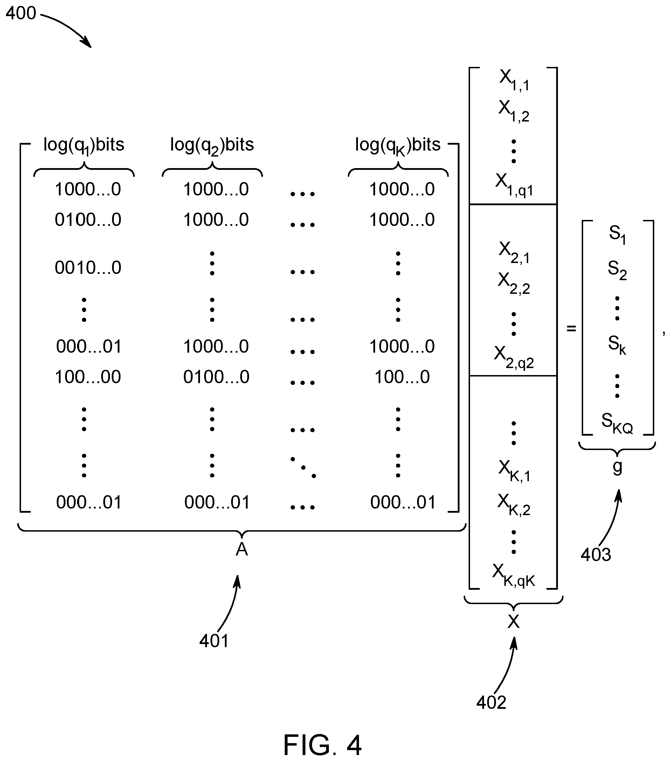

Fig. 4 shows a mathematical representation (400) of one embodiment of the presently disclosed decoding scheme. In Fig. 4, (401) is a binary matrix that selects all possible cases of users, or transmitting digital units, to send their digital data. Vector (402) represents the transmitted constellation points for K users. Vector (403) represents all constellation points for all the possible superpositions in the time-invariant or time-variant channel.

*Method details*

The transmitting encoding schemes or modulations may be PSK, QAM, FSK or any analog or digital encoding scheme or modulation. The transmitting encoding schemes may be standard analog or digital encoding schemes or may be arbitrary analog or digital encoding schemes, but they may be known to the receiver and to the decoding scheme. That is, the programmer that implements the presently disclosed decoding scheme may input the type of encoding scheme for the transmitted data as a parameter of the presently disclosed decoding scheme. The transmitting encoding schemes may be the same encoding schemes for all users or transmitting digital units, or they may be different encoding schemes.

In one embodiment of the present disclosure, the superpositions of transmitted encoded data are obtained, in the time-invariant or time-variant channel, by interference of transmitting signals carrying the transmitted data. As transmitted signals are encoded or modulated and sent to a same time-invariant or time-variant channel, they interfere with each other generating superpositions, wherein superpositions are results of interferences of encoded or modulated transmitted data, for example in the amplitude-phase domain. It is an advantage of the present disclosure that interferences in the amplitude and phase domain are used and that superpositions of encoded transmitted data are superpositions in the amplitude and phase space.

In one embodiment of the present disclosure, the decoding scheme comprises more constellation points, such as constellation points in amplitude and phase space, as compared to the constellation points of the transmitting encoding schemes. As shown as an example in Fig. 2, the constellation of the superpositions (205) has a higher number of points in the amplitude and phase space than the number of points of the constellation of the first user or transmitting unit (201) or the number of points of the constellation of the second user or transmitting unit (202).

In one embodiment of the present disclosure, the decoding scheme comprises a number of constellation points equal or more than a number of possible combinations of input data or transmitted data. As the presently disclosed method may decode any combination of the input data, it is advantageous that the decoding scheme assigns to each superposition of the transmitted data a value corresponding to a unique combination of the input data and that there are at least as many superposition points in the superposition constellation as there are combinations of the input data.

In one embodiment of the present disclosure the transmitting encoding scheme and the decoding scheme associate each superposition of the digitally encoded input data with a predefined unique combination of input data. The input data may comprise input data from at least first input data, transmitted using a first transmitting digital unit, and second input data, transmitted using a second transmitting digital unit

The input data may encoded according to a digital modulation scheme. More specifically, the digital modulation scheme may be an amplitude-based and phased-based modulation scheme. The step of transmitting digitally encoded input data may accordingly comprise changing the phase and amplitude of transmitted signals representing the input data.

On the receiver side, the step of decoding the superpositions of transmitted digitally encoded input data may comprise determining the phase and amplitude of the transmitted signals comprising superpositions of the digitally encoded input data, and mapping the signals to predefined combination or functions of the input data.

In one embodiment of the present disclosure, transmitted digital data are transmitted over signals with different transmission power. The use of different transmission power for some or a group or all of the transmitting units is advantageous as it allows generations of a greater number of points in a superposition constellation. Therefore, the use of different transmission power may be advantageous in obtaining enough points in the superpositions constellation, such as to obtain at least one superposition point for each combination of the transmitted digital data. For example the transmitted data is typically encoded in an amplitude and phase space. If the transmitted power is different for different users or different transmitting units, the points in the constellations of the transmitted data for the different users or different transmitting units will be characterized by different amplitudes and the number of superpositions points will be higher as compared to a case where all the users or transmitting units transmit with the same transmitting power, as the amplitudes of the transmitted constellation points in the amplitude and phase plane may be related to the transmitted power. The superposition points may be interferences of transmitted data, and may therefore depend on both amplitude and phase of the encoded transmitted digital data.

In one embodiment of the present disclosure, transmitted data are transmitted through a same time-invariant or time-variant channel. In order to obtain in-channel computations it is advantageous that the transmitting units transmit data on the same channel. In particular the transmitting units may transmit on the same carrier frequency and at the same time, in order to obtain interferences in the channel and therefore in order to obtain superpositions of encoded or modulated data.

In the presently disclosed method, the combinations or functions of input data may be sums, or weighed sums, or multiplications, or mathematical operations, or logic operations, or binary operations, or boolean operations, or any other computation that can be expressed by a mathematical function of the input data. As the presently disclosed method assigns to any superposition of encoded data in the time-invariant or time-variant channel a value corresponding to a combination or function of input data, such a combination may be arbitrary and may be defined in the decoding scheme as any mathematical operation between transmitted digital data. That is very advantageous as the presently disclosed method may solve a large variety of problems related to computation. For example, if the combinations or functions of input data are, in one embodiment, assigned to weighed sums of input data and if the input data are gradients or parameters of machine learning models, the presently disclosed method may perform in-channel computation of a federated average of machine learning models and the receiver may simply decode the superpositions as federated average of parameters or gradients of machine learning models, without the need for the receiver to perform the federated average computation in-situ, as that computation has already been performed in the channel by generation of superpositions of encoded data. In the present disclosure, the receiver may simply decode the superpositions based on the presently disclosed decoding scheme. This fully analog or digital in-channel computation brings the benefits of saving time, computation resources and power consumption, together with being fully compatible with fully digital communication systems or with general analog communication systems based on both amplitude and phase modulation, or with mixed systems.. The decoding may be done by the receiver based on the presently disclosed decoding scheme which, in this embodiment, may assign to each superposition point in the superposition constellation a weighed sum of the input data. The presently disclosed scheme may be based on a look-up table (LUT).

In one embodiment of the present disclosure, the decoding scheme or demodulation is based on a function that assigns a unique combination of input data to a unique superposition of transmitted encoded digital data. This is advantageous as it makes the decoding computable, that is that for each detected superposition a unique combination of transmitted data is determined. Whenever computability of the decoding scheme may not be achieved directly, transmission power or phases of the different users or transmitting units may be tweaked and differentiated in order to obtain more superposition constellation points.

The superpositions of the transmitted digitally encoded input data may have a number of superposed constellation points greater than constellation points of digital modulation scheme used for encoding the input data. An example of this is shown in fig. 2. The digitally modulated input data has 4 constellation points, whereas the superposed constellation points have a total of 9 constellation points. The step of decoding the superpositions of transmitted digitally encoded input data may comprise extracting the unique combinations for the received superpositions of transmitted digitally encoded input data.

In one embodiment of the present disclosure, the transmitted data from the transmitting units are transmitted at a same carrier frequency.

In one embodiment of the present disclosure, the transmitted data from the transmitting units are transmitted at a same time.

In one embodiment of the present disclosure, the encoded data from the transmitting units are encoded with the same transmitting encoding scheme.

In a traditional communication system data is transmitted from the transmitters to the receiver through the channel, but no computation is done in the channel. For this reason, in a typical communication system different users or different transmitting units have dedicated frequencies or time slots, or encoding schemes and are therefore separated from each other in at least one of these three domains: frequency domain, time domain, coding domain. In the presently disclosed method a part of the computation happens in the channel and is based on interference of transmitted data. For this reason transmitted data may be sent at same carrier frequency and at the same time, and they may use the same encoding scheme.

In one embodiment of the present disclosure the decoding scheme is implemented in a look-up-table (LUT).

In one embodiment of the present disclosure, decoding further comprises error correction, and/or synchronization, and/or acquisition of channel state information.

In one embodiment of the present disclosure, when digital modulations are used with with digital transmitters or transmitting digital units and a digital receiver, the presently disclosed method may leverage all the advantages of digital systems, such as error correction, and/or synchronization, and/or acquisition of channel state information and all other features that are typical of fully digital communication systems.

In one embodiment of the present disclosure, transmitted data or input data are gradients and/or parameters of a machine learning model.

In one embodiment of the present disclosure the combination of input data or transmitted data is a federated average of machine learning models. In this embodiment the in-channel computation is performing a federated average of parameters or gradients of machine learning models. That is very beneficial in the context of Internet of Things, as federated averages are widely used for many applications, such as outlier identification or malfunctioning of devices or many other applications such as virtual reality, edge computing, edge learning. In one embodiment, the presently disclosed method is robust to noise in the channel. As channels may present noise, in form for example of white Gaussian noise, the presently disclosed method may account of the noise and the error due to the noise for the definition of the decoding scheme in order to minimize decoding error. In particular the decoding scheme may be designed to minimize the maximum error, and/or the decoding scheme may be designed to minimize the average error. The inventors have realized that the problem of minimizing the maximum error and/or the problem of minimizing the average error have solutions that may be implemented in the decoding schemes, for a broad number of functions or combinations of input or transmitted data.

The present disclosure further relates to a computer program having instructions which, when executed by a computing device or computing system, cause the computing device or computing system to carry out any embodiment of the presently disclosed method for in-channel function computation in a digital communication system comprising a plurality of transmitting digital units and one or more time-invariant or time-variant channels. The computer program may be stored on any suitable type of storage media, such as non-transitory storage media.

*System*

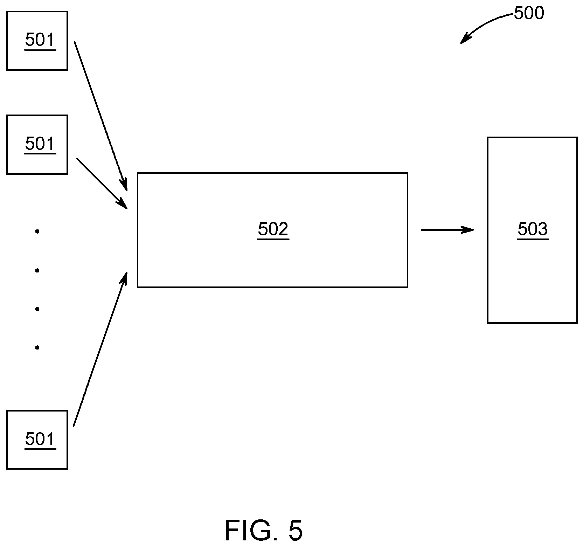

Fig. 5 shows one embodiment of the presently disclosed system (500), comprising a plurality of transmitters or transmitting units (501), one or more time-invariant or time-variant channels (502) and a at least one receiver (503).

In one embodiment of the present disclosure each of the transmitting units is transmitting by fully digital modulations or encoding and the receiver is fully digital. The transmitted digital data is encoded or modulated according to standard or arbitrary encoding or modulation schemes. The transmitted encoded or modulated data interferes in the time-invariant or time-variant channel giving rise to superpositions of data. Said superpositions are decoded by the receiver according to a decoding scheme that assigns, to each superposition, a predefined value corresponding to a combination of input data. This embodiment of the presently disclosed system is fully digital, that is the transmitting units transmit digitally encoded or digitally modulated data, the channel is configured to carry digitally encoded or digitally modulated signals and the decoder is configured to decode superpositions of digitally encoded data, based on the presently disclosed digital decoding scheme.

In one embodiment of the present disclosure, the one or more time-invariant or time-variant channels are wireless channels. That is advantageous, for example, for in-channel communication over a wireless network, or over a cellular network or over a local area network, or over a personal area network.

In one embodiment of the present disclosure, the one or more channels are optical channels, such as optical fiber links. That is advantageous, for example for a communication over the Internet.

In one embodiment of the present disclosure, the one or more channels are visible light channels.

In one embodiment of the present disclosure, the one or more channels are quantum channels.

In one embodiment of the present disclosure the one or more channels are acoustic channels.

In one embodiment of the present disclosure the one or more channels are electric channels, such as copper wires.

In one embodiment of the present disclosure the one or more channels are molecular channels, such for in-body transmissions.

In one embodiment of the present disclosure the one or more channels are wires within an electronic chip, such in electronic chip design. This may be advantageous, for example, in systems on electronic chips.

In one embodiment of the present disclosure, the one or more channels are on-chip channels and the transmitting units and the receiver are on-chip.

In one embodiment of the present disclosure the system is a multi-input-multi-output (MIMO) system. That may advantageous, for example, in 5G or 6G mobile networks.

In one embodiment of the present disclosure, the one or more channels are capable to transmit analog or digitally modulated signals.

*Receiver*

The present disclosure further relates to a digital communication receiver, configured to decode in-channel superpositions of digital data from digital transmitters according to a decoding scheme which assigns, to each superposition, a predefined value corresponding to a predefined combination of transmitted digital data.

In one embodiment of the present disclosure, the presently disclosed receiver decoded superpositions of digital data based on a decoding scheme implemented in a look-up-table (LUT).

In one embodiment of the present disclosure, the receiver is configured to identify and decode a unique time sequence of constellations from asynchronous transmitters.

*General*

The presently disclosed method may be implemented in the presently disclosed system.

The presently disclosed system may be configured to perform the steps of the presently disclosed method.

The presently disclosed receiver may be part of the presently disclosed system and/or may be configured for performing the step of decoding according to the presently disclosed method.

The digital communication system may further comprise peripheral components, such as one or more memories, which may be used for storing instructions that can be executed by any of the processors. The digital communication system may further comprise internal and external network interfaces, input and/or output ports, a keyboard or mouse etc.

As would be understood by a person skilled in the art, a processing unit also may be a single processor in a multi-core/multiprocessor system. Both the computing hardware accelerator and the central processing unit may be connected to a data communication infrastructure.

The digital communication system may include a memory, such as a random access memory (RAM) and/or a read-only memory (ROM), or any suitable type of memory. The digital communication system may further comprise a communication interface that allows software and/or data to be transferred between the system and external devices. Software and/or data transferred via the communications interface may be in any suitable form of electric, optical or RF signals. The communications interface may comprise, for example, a cable or a wireless interface.

*Synchronization*

In one embodiment of the present disclosure, the transmitting units may transmit data asynchronously. For example a first group of transmitting unit may transmit at time T1, a second group of transmitting unit may transmit at time T2 and a third transmitting unit may transmit at time T3. That may result in a sequence of constellation points, for example constellation Q1, constellation Q2 and constellation Q3 corresponding to times T1, T2 and T3 respectively. In the present disclosure, phase and amplitude of the encoded or modulated signals may be chosen in such a way to make such a sequence of constellation points unique for each possible combination of input data. Therefore, in the present disclosure, the receiver may be configured to identify any unique sequence of constellations and therefore associate to each of these unique sequences a unique combination of input data.

In one embodiment of the presently disclosed method, the encoded data from the plurality of transmitting digital units is transmitted asynchronously and is decoded based on a unique time sequence of superpositions.

*Analog modulation*

In one embodiment of the present disclosure each of the transmitting units is transmitting by any analog modulation and the receiver is fully analog. The transmitted data is encoded or modulated according to standard or arbitrary analog modulation, not restricted to amplitude modulations. The transmitted digital data interferes in the time-invariant or time-variant channel giving rise to superpositions of transmitted data. Said superpositions are decoded by the receiver according to a decoding scheme that assigns, to each superposition, a predefined value corresponding to a combination of transmitted data. This embodiment of the disclosed system is fully analog, that is the transmitting units transmit analog modulated data, the time-invariant or time-variant channel is configured to carry analog modulated signals and the decoder is configured to decode superpositions of analog modulated data, based on the presently disclosed decoding scheme.

**Examples**

The presently disclosed method, system and receiver are in the following section described with reference to examples. The examples shall not be seen as limiting for the present invention.

The technology underlying the presently disclosed method and system may be referred to as ChannelComp, which may be an abbreviation of Channel Computing, and wherever used in this text, the word ChannelComp may refer to the presently disclosed method and system and receiver.

Over-the-air computation (AirComp) is a well known technique by which several wireless devices transmit by amplitude analog modulations to achieve a sum or function of their transmit signals at a common receiver. The underlying principle is the superposition property of the radio waves. Due to that such superposition is analog, it is natural that AirComp use amplitude analog modulations and analog hardware to obtain analog sum of signals. Unfortunately, this is impractical because rarely wireless devices today use amplitude analog modulations. It would be highly desirable to use more general anaog modulations than amplitude modulations, and also digital communications, because of the numerous benefits that they offer such as error correction, synchronization, acquisition of channel state information, software nature, and widespread use. However, when using analog modulations more general than amplitude analog modulations, or digital modulations for AirComp, a general belief is that the superposition property of the radio waves returns incomprehensible overlapping of the signals. The present disclosure breaks through such belief and discloses ChannelComp, an entirely new digital communication system and method, that allow to use general analog modulations as well as digital modulations. The inventors define the presently disclosed method as ChannelComp method.

ChannelComp inherits all the digital communication benefits, as well as the benefit of general analog modulations. In contrast to AirComp, ChannelComp can be implemented as a pure software method that is compatible with current digital technologies. ChannelComp can be used for all the use-cases of AirComp such as distributed machine learning and artificial intelligence, without waiting for the daunting if not impossible task to re-equip wireless devices with amplitude analog modulations. ChannelComp has the potential to be a new disruptive technology for the future generation wireless systems, and to enable groundbreaking new services such as artificial intelligence, augmented and virtual reality over networks, or safe autonomous driving and flying.

Towards implementing the idea of the internet of things (IoT), which can reshape our lifestyle through providing ubiquitous connectivity of almost everything, the generations of wireless communications have been accompanied by a paradigm shift from human-type communications to machine-type communications. On the one hand, the number of IoT devices is predicted to reach 75 billion by 2025, much larger than that of mobile phone users. On the other hand, the various IoT applications based on machine learning (ML) are set to emerge in 6G, which require collecting, transmitting, and performing calculation of enormous amounts of data from many devices. Consequently, extensive connectivity needs to scaled-up radio and computation resources, which means swamping the capacity of the current systems. To better support emerging compute-intensive ML applications, e.g., virtual reality, edge computing, edge learning, especially federated learning, over the air computation (AirComp) is a promising concept to simultaneously collect and compute data at the edge network.

The AirComp solution leverages the waveform superposition property of the multi-access linear time-invariant channel to realize aggregation of data simultaneously transmitted by devices, allowing each device to access all radio resources, unlike the standard transmit-then-compute scheme. Moreover, the AirComp approach integrates communication and computation steps and provides ultra-fast wireless data aggregation in IoT networks with high-spectrum efficiency. AirComp reduces the required energy of each device for transmission while it can bring high rate communication thereof by harnessing interference to help functional computation. Besides preserving the privacy and security of data, the coverage area can also be enlarged since more devices can transmit at the same time and frequency.

However, AirComp must use a special analog communication system, where the communication happens via amplitude analog modulations. This is highly impractical because almost no device today uses the simple amplitude analog communications of AirComp. AirComp would thus require a new communication hardware. Instead, in this document the inventors disclose a channel computing (ChannelComp) method that is fully compatible with existing digital communication systems such as those currently available on any smartphone or IoT system. Moreover ChannelComp does not require new hardware, because may be fully software. ChannelComp can be implemented both via any analog modulation (not restricted to amplitude modulation) and digital modulation. The inventors have established the broad set of functions that ChannelComp may compute and propose the methods that make it possible to any modulation scheme to perform computations.

The presently disclosed ChannelComp overcomes the limitation of AirComp due to the use of analog amplitude modulations, and uses instead any analog modulation or digital modulations. The compatibility with digital modulations makes it possible to benefit from all the digital communication methods such as error correction, synchronization, and acquisition of channel state information. Thus, contrarily to AirComp, ChannelComp is a pure software invention that is compatible with digital technologies already present in the current 5th generation (5G), and in most any digital communication system.

The present disclosure dramatically improves the use of communication resources (energy, time, frequency), which are an important need to IoT for ML or artificial intelligence (AI) services. Thus, ChannelComp may be used to make the complex AI/ML computations over-the-channel and thereby greatly accelerating the AI/ML algorithms. To be concrete, an application example of ChannelComp is the use of distributed ML/AI over a camera network to monitor events such as accidents or traffic in a city or the appearance of obstacles while driving a car.

One benefit of the presently disclosed solution is the use of existing digital systems to implement ChannelComp. If we wish to implement AirComp on existing digital systems, it is necessary to enforce amplitude analog communication systems to work on top of current digital systems, which is very difficult and impractical. This enforcement works in very few and very specific cases, and the results are highly inefficient in terms of communication resource usage. One such AirComp enforcement on top of digital communications has been recently proposed, named one-bit broadband digital aggregation (OBDA), but only works for binary phase shift key (BPSK) and quadratic phase shift key (QPSK) digital modulations. These are extremely simple digital modulation format. In contrast, the presently disclosed method and system ChannelComp works on a broad set of functions, combination of transmitted data and uses digital modulations as well as any analog modulation. Moreover, due to that AirComp is not conceived for digital communication, the performance of such application is highly inefficient. AiComp's non-coherent communication solution for single and multi cell using pulse-position modulation and frequency-shift keying (FSK) both are limited to signSGD problem, like OBDA, and AiComp extension to general function computations is at the moment not known. In summary, the application of AirComp to digital modulation or general analog modulations is restricted to very few cases and to limited functions, with inefficient performance.

Differently than OBDA, the presently disclosed ChannelComp may be compatible with any digital or analog modulation. The presently disclosed method ChannelComp may use any currently available digital systems (which are almost everywhere used) instead of amplitude analog modulations (which are very rarely used) of AirComp. The amplitude analog systems must be tailored hardware-wise to analog AirComp, which do not exist yet today. Hence, the presently disclosed solution is purely software and leverages current digital systems to make the function computation over-the-channel and benefits in terms of the existing digital communications structure, including error correction, synchronization, and acquisition of channel state information. This may enable a quick adoption of ChannelComp method in current and future devices, including IoT devices, and systems. This quick adoption may likely generate huge economical savings for operators and companies in the telecommunication industry due to the use of already available digital infrastructure.

AirComp's main drawback is to rely on amplitude analog communications, which are almost never used today. Moreover, analog communications are not robust to the communication channel errors that introduce an inevitable error at the receiver device. The error cannot be removed by forward error correction as possible in digital systems. AirComp can only be used for linear time-invariant channels.

Within AirComp, the closest solution is OBDA, which forces analog communications into digital modulations. In OBDA, analog transmissions are used together with digital orthogonal multiple-access schemes, such as orthogonal frequency division multiplexing (OFDM) transceivers, and digital modulation schemes, such as BPSK and QAM. But result is order of magnitudes less efficient in terms of communication resources than ChannelComp. In addition ChannelComp may be extended to any function and therefore to any of the existing digital modulations, or even to other arbitrary digital modulations. Moreover ChannelComp can be a fully software method which may be implemented in a fully digital communication system.

*ChannelComp: Computation over the MAC by Digital Modulations*

Consider a communication network in which there exist a computation point (CP) together with $K$ nodes. The computation point may be a common receiver connected by shared time-invariant or time-variant channels to the nodes.

The CP aims to compute a desired function $f(x_1, x_2, \ldots, x_K)$ whose $x_k \in \mathbb{F}_q$ is a value owned at the $k$-th node. In particular, the assumption is that the nodes transmit messages by digital communications. In this digital communication system, all the nodes transmit their values $f$ at the CP. $k$-th $x_k(t)$ node digital transmits the value at time $t \in \mathcal{T}$ where $\mathcal{T} = \{1, 2, \dots, T\}$ denotes the set of time slots of interest for a sufficiently large number $T$. To perform such digital transmission, the usual digital procedure is the following: each value $x_k(t)$ is quantized into a length $q$ vector $\widetilde{x_k}(t)$, (where $q$ equals 2 to the power of number of bits), thereafter the resultant vector is mapped into the digitally modulated signal $\vec{x_k}(t)$ using encoder $\varepsilon_k(.)$ i.e

$$\vec{x_k}(t) = \mathcal{E}_k\left(\widetilde{x_k}(t)\right).$$ The signal $\vec{x}_k(t)$ is what node $k$ transmits over the communication time-invariant or time-variant channel. Since all the nodes transmit simultaneously, CP receives the summation of all $\vec{x}_k(t)$s over MAC at the time $t$, i.e.

$$\vec{y}(t) = \sum_{k=1}^{K} \vec{x}_k(t) + \vec{z}(t), \quad \forall t, \text{ (eq. 1)}$$

where $\vec{y}(t)$ is physically generated by the superposition nature of electromagnetic waves, and $\vec{z}(t)$ is a receiver noise that the receive antennas unavoidably capture. Following the usual modeling in digital communications, such noise may be modeled as a white Gaussian noise (AWGN) process with zero-mean and variance $\sigma_z^2$. Note that each digital signal $\vec{x}_k(t)$ is selected from finite q chosen modulation signal, thereby $\vec{y}(t)$ has finite constellation points. The summation in eq. 1 induces a specific constellation diagram of $y$ which depends on the number of nodes K and which modulation has been used for each $\vec{x}_k(t)$ e.g. Fig. 2 shows this deformation for the case of using BPSK for two users i.e. $K = 2$.

To compute $f$, one needs to use mapping (association function) $\mathcal{T}(\vec{y}(t))$ based on the resultant constellation diagram of signal $\vec{y}(t)$. More precisely, the mapping $\mathcal{T}$ must be determined such that its output approaches the value of the function much as possible. In mathematical terms, at time $t$, map T can be found from the following optimization (2)

$$\mathcal{T}^* = \underset{\mathcal{T}}{\arg\min} \ \sum_{x_1,\dots,x_K \in \mathcal{D}_f} |f(x_1(t), \dots, x_K(t)) - \mathcal{T}(\vec{y}(t))|^2$$

Here, $D_f$ is the domain of function $f$.

To illustrate optimization problem (2), consider a simple noiseless scenario in which transmitters use BPSK modulation and the desired function $f$ is the summation function for two users $K = 2$. The users send $\{-1,1\}$ and CP receive $\{-2,0,2\}$ as sum over the air, since. Here, the association tabular $\mathcal{T}$ is nothing expect a simple map that assign values of the constellation diagram of $\vec{y}(t)$ to the corresponding output of $f$ i.e.

$$\mathcal{T}(\{-2\}) = 0, \quad \mathcal{T}(\{0\}) = 1, \quad \mathcal{T}(\{2\}) = 2$$

where $\mathcal{T} : 4 \mapsto 3$ is a map can be uniquely determined based on which kind of modulation is used for $x_k(t)$ for $k \in \mathcal{K}$, in addition to which characteristics of the function $f$ has

Therefore, in the next section, the characteristics of the desired function and the employed modulation are discussed. Then, possible choices of $\mathcal{T}$ from the minimization in (2) will be highlighted.

*Uniform Modulation*

Without using precoders, computing all types of functions may not be achievable when all $K$ nodes use same modulation. Hence, there is a class of function $f$ with some specific features that it can be perfectly computed by using digital communication. Let $\varepsilon(.)$ be the modulation used by all nodes to send the data over the air. Then, received signal by CP has different constellation points formed by summation of $\Sigma_{k \in [K]} \varepsilon(x_k)$. Then, the remained question is which functions are computable using this communication architecture?

In the following, a necessary condition on the function $f$ in order to be determined uniquely by using an appropriate tabular function $\mathcal{T}$ is brought.

Proposition 1: The $K$ multivariate function $f(x_1, x_2, \dots, x_K)$ with domain $\mathcal{D}_f$ where $x_k \in \mathcal{D}_f$ for $k \in [K]$ is the desirable function. Using identical modulation, all the users use the modulation $\varepsilon$. Then, function $f$ can be uniquely determined by the constellation diagram of $\sum_{k=1}^{K} \mathcal{E}(x_k)$, iff is a symmetric function with respect to all input variables in its domain i.e. the function is unchanged by any permutation of its variables.

*Proof.* For simplicity, we assume $K = 2$, and $f(x_1, x_2)$ is not a symmetric function i.e. $f(a, b) \neq f(b, a)$ where $a, b \in \mathcal{D}_f$. Then, for a case where $x_1 = a$ and $x_2 = b$, we have $\vec{a}$ and $\vec{b}$ as modulated signal thereof and $\vec{a} + \vec{b}$ would be received by server, accordingly. It is easy to see that for the reverse scenario i.e. $x_1 = b$ *and* $x_2 = a$ the server also observe$\vec{a} + \vec{b}$. Therefore, we have same constellation point for the different values of asymmetric function *f* and it is impossible to assign the same vector $\vec{a} + \vec{b}$ to the two different values of *f(a, b)* and *f(b, a)*.

Here, the modulation and the domain may not be determined. Therefore, the proposition is valid for any arbitrary modulation with different number of bits for each user. If one restricts the domain to binary, this condition can be also sufficient. In fact, for one bit communication this argument is the only required condition for the function *f* to be computed correctly.

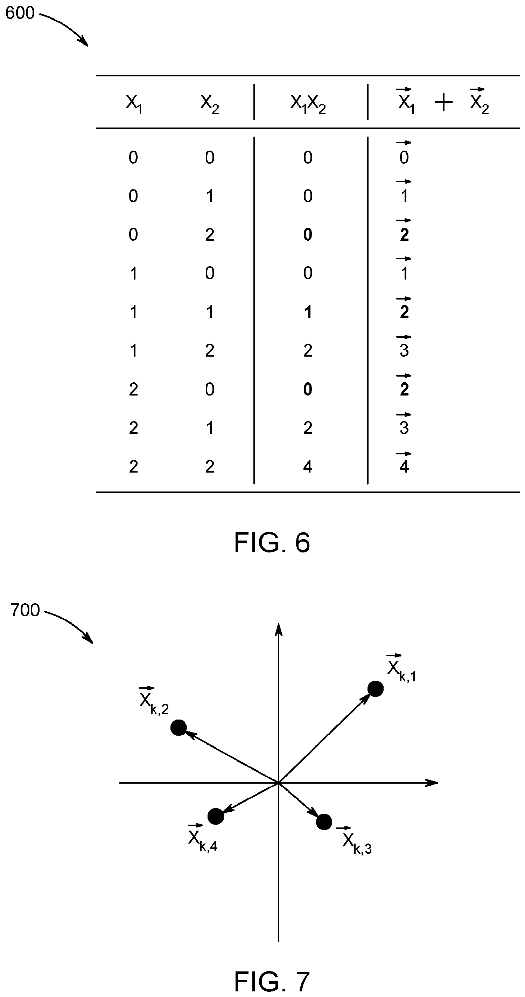

To see why this condition is not a sufficient condition, one can check a simple function $f(x_1, x_2) = x_1 x_2$. Indeed, instead of one bit for each user if we enlarge the domain to two bits for instance, then there could be exist some points that have different values of a certain constellation point. For instance, Table Fig. 6 shows a counter example for this case. Fig. 6 shows a counter example to show that being symmetric is not sufficient to be computable. Here, $x_1 x_2$ is a symmetric function respect to $x_1$ and $x_2$ while we can not compute this function because of conflict occurs on point $\vec{2}$. In fact, it needs to assign simultaneity this constellation point to the two different values 0 and 1 which is impossible.

To give insight, one may consider the summation $\sum_{k=1}^{K} \mathcal{E}(x_k)$ as a function that map the $q^K$ points in the domain of function to a lower number of constellation points over the air. Moreover, if we define $R_s$ as range set of summation $\sum_{k=1}^{K} \mathcal{E}(x_k)$ and $R_f$ to be the range of desired function *f*. Then, one has the following lower and upper bound on cardinality of $R_s$ when using same modulation.

Proposition 2: Assume that one has K different points $x_k$ which each one consists of *q* distinct points in 2D space. Then, the aggregation of the modulated signals i.e. $\sum_{k=1}^{K} \mathcal{E}(x_k)$ can not impose lower than $(q - 1)K + 1$ number of distinct constellation points and greater than $\binom{K+q-1}{q-1}$. In other words, for the range of summation $R_s$ we have that

$$(q - 1)K + 1 \leq |R_s| \leq \binom{K + q - 1}{q - 1}$$

The upper bound and lower bound in (2) are also the limitation on the symmetry function. As a result, if the range of desirable function f be greater than existed points by the constellation points i.e. $|R_f| \geq |R_s|$, then it may be impossible to cover perfectly all the range of function.

As mentioned earlier, using same modulation would limit us to the symmetric function. To go beyond symmetric function, one needs to change the modulation in a such way that allows us to compute any class of function. In what follows, one looks for a finding the best possible modulation under different scenarios in order to obtain a reliable computation over the network.

*Analog Modulations*

It should be highlighted that the modulation $\varepsilon(.)$ can be any type of analog or digital modulation, regardless of it has an analog or digital carrier, or the input of the data is digital or analog. For the digital carriers such as pulse amplitude (PAM), pulse position (PPM) and etc., one can solve the problem for each symbol per time and decode the data in a sequence of time. For the analog data, using the quantization step (see Fig. 2) allows to perform ChannelComp for either analog modulation such as amplitude (AM), phase (PM), and frequency modulations (FM), or digital modulation e.g. ASK, PSK, FSK, and QAM. As long as input data are finite points, the resultant overlapped signal would read to finite constellation points which accordingly lets the desired function *f* to be computed by designing a proper tabular function $\mathcal{T}$ to map the finite constellation points to the output of the function *f*. To be more specific, let $x_1, x_2 \in \mathbb{R}$ be the input values of the first and the second users, respectively. The quantization converts the $x_1$ and $x_2$ into $\widetilde{x_1}, \widetilde{x_2} \in \{0, 1, ..., q - 1\}$ where q shows the quantization levels. Next, using any analog modulation for transmitting $\widetilde{x_1}$ and $\widetilde{x_2}$ would lead to at most $q \times q$ different points each point can represent different amplitudes or phases. Since received signals have finite constellation points, one can a tailor tabular $\mathcal{T}$ which maps $q^2$ points to the output of the range of function $R_f$. In this regime, the communication system does not need to be changed and the only requirement is to add quantizer to the transmitter and tabular function to the receiver side.

*Modulation Selection in ChannelComp*

As mentioned, to transmit the value of *k*-th node using BPSK modulation over the AWGN channel, one first

quantizes the scalar $x_k(t)$ to $q$ bit values and then modulates it by a carrier. For the case of BPSK modulation, the scalar $x_k(t)$ is one-bit quantized to $\tilde{x}_k \in \{0,1\}$ for which we have $\tilde{x}_k = x_k(t) + q_k(t)$ where $q_k(t)$ denotes the quantization error of the $k$-th symbol. The resultant symbol modulated by a basis signal $\vec{x}_k(t)$ where

$$\mathcal{E}_k(\tilde{x}_k) = \begin{cases} E\cos(2\pi f_c t + \pi), & \tilde{x}_k = 1 \\ E\cos(2\pi f_c t), & \tilde{x}_k = 0. \end{cases}$$

Here, E and $f_c$ are amplitude and frequency of the career signal, respectively. In the sequel, to alleviate notation for general cases, one uses representation of band-pass signals where allows to represent a signal by only its amplitude and phase. Particularly, one expands a general form of the cosine function as follows

$$\begin{aligned} \vec{x}_k(t) &= E_k\cos(2\pi f_c t + \varphi_k), \\ &= E_k\cos(\varphi_k)\cos(2\pi f_c t) + E_k\sin(\varphi_k)\sin(2\pi f_c t) \\ &\qquad\quad \underbrace{\phantom{E_k\cos(\varphi_k)}}_{E_{1,k}} \qquad\qquad\qquad \underbrace{\phantom{E_k\sin(\varphi_k)}}_{E_{2,k}} \\ &= E_{1,k}\cos(2\pi f_c t) + E_{2,k}\sin(2\pi f_c t), \end{aligned}$$

This expression is desired form for the representation of a band-pass signal $\vec{x}_k(t)$ where $E_{1,k}$ and $E_{2,k}$ are well known as quadratic components of the band-pass signal. In the signal space domain, $\vec{x}_k(t)$ can be considered as a complex like $x_k \in \mathbb{C}$ whose real and imaginary parts are $E_{1,k}$ and $E_{2,k}$, respectively. The complex number $x_k$ also can be seen in the polar domain with amplitude $E_k$ and phase $\varphi_k$ that shows one bit data. To generalize the problem, the inventors assume k-th user transmit $q_k$ over the communication time-invariant or time-variant channel which equivalently means $x_k$ has $q_k$ complex numbers to transmit. Therefore, one can represent modulated signal $\vec{x}_k(t)$ by a complex vector $\mathbf{X}_k \in \mathbb{C}^{q_k \times 1}$ where $x_{k,i}$ shows element $i$-th of this vector (e.g. see Fig. 7). Furthermore, the inner product of two complex signals $\vec{x}_k$ and $\vec{x}_\ell$ defined on interval $[a, b]$ is considered as inner product of continuous functions i.e.

$$\langle \vec{x}_k(t), \vec{x}_\ell(t) \rangle = \int_a^b \vec{x}_k(t)\vec{x}_\ell^*(t)dt,$$

Subsequently, two signals are not linearly independent unless their inner product be zero. Also, the norm of signal $\vec{x}_k$ is defined

$$\| \vec{x}_k(t) \| = (\int_a^b |\vec{x}_k(t)|^2 \, dt)^{1/2},$$

We recall the received signal by CP i.e. $\mathbf{y}(t)$ is equal to $\Sigma_k \vec{x}_k$ which has finite constellation points. Invoking the complex vector representation of each $\mathbf{x}_k$, we can represent all possible constellation points as shown in Fig. 4, where $\mathbf{A} \in \{0,1\}^{\prod_{k=1}^K q_k \times \Sigma_K q_k}$ is a binary matrix that select the all possible cases of users to send their data and the vector $\mathbf{X} \in \mathbb{C}^{\Sigma_K q_k \times 1}$ consist of all $K$ block of complex vector where block $k$-th is a modulation of corresponding node i.e. node $k$-th. Also, $(\Sigma_K q_K) \times 1$ vector s denotes all possible constellation points over the channel. For simplicity, the inventors may assume all the users send exactly $\log(q)$ number of bits. To alleviate the notation, let $N := qK$ and $M := q^K$, then $\mathbf{A} \in \{0,1\}^{M \times N}$ and $\mathbf{X} \in \mathbb{C}^{N \times 1}$.

*Feasibility Check*

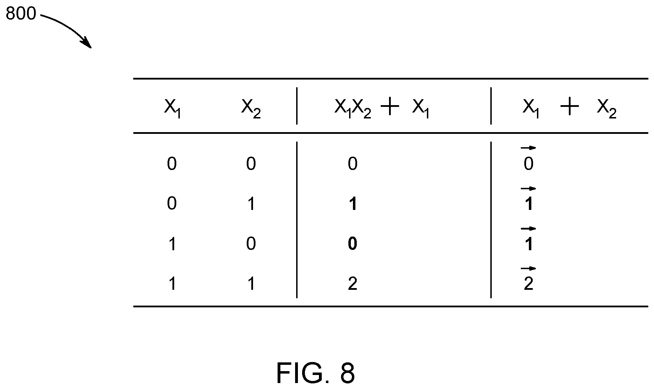

In order to compute the function $f$ associate with modulated signal $x_1, \ldots, x_K$, one needs to make sure that employed modulations for nodes are able to compute accurately the desired function. the first necessary condition under which prefect computation can be possible is related to range of function $R_f$ and rang of the summation over the channel $R_s$. Indeed, the number of constellation points at receiver has to be greater than range of function $f$ i.e. $|R_s| \geq |R_f|$. To illustrate that this condition is not sufficient, one can consider function $f$ to be $x_1x_2 + x_1$ for $x_1, x_2 \in \{0,1\}$ where the signals modulated using BPSK. In Fig. 8, the inventors depicted the ranges points of the function $f$ and summation over channel i.e. $\Sigma_{k \in [K]} \vec{x}_k$.

While having $|R_s| = |R_f| = 3$, the function $f$ can not be computed by this communication model (modulation).

Fig. 8 shows a counter example to demonstrate that $R_s \geq R_f$ is not enough to compute function $f$. Since there exist a conflict on point $\vec{1}$, we ca not compute the function while $R_f = R_s = 3$.

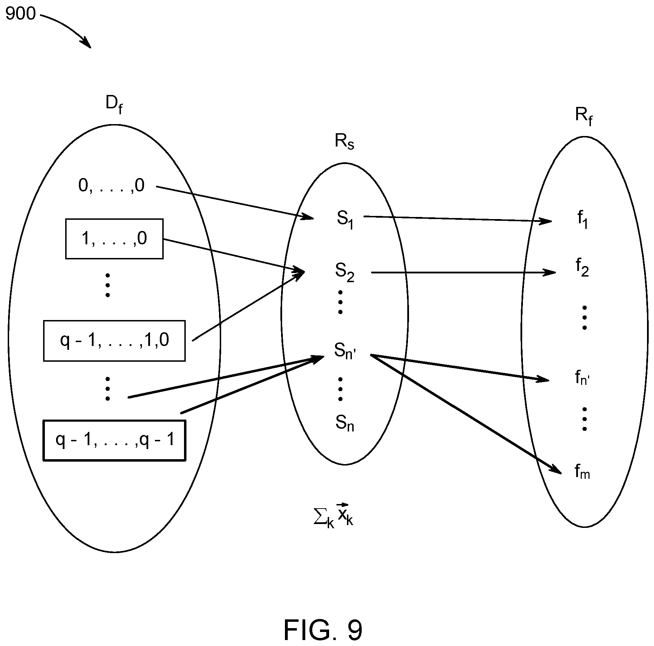

Furthermore, it requires that the $\Sigma_K \mathbf{x}_k$ covers all the range of function $f$. In fact, for $i \in [M]$, let $f_i$ be an output of function $f$ for a certain value of input $x_1, x_2 \ldots, x_K$ where all $x_K$s have same q possible values. Then, if $f_i$ is different from $f_j$, it requires the correspondence constellation point $s_i$ also must not be as the same as $s_j$ for $i \neq j$ see Fig. 9. Therefore, to verify that given modulation signals are suitable for computing the desired function $f$, one can solve the following problem (10)

$$\mathcal{P}_1 = find \qquad\qquad \mathbf{x}$$
$$s.t. \qquad\qquad f_i \neq f_{j \Rightarrow} s_i \neq s_j,$$
$$\forall (i,j) \in [M] \times [M],$$

in which $\mathbf{x} \in \mathbb{C}^{N \times 1}$ is the modulation vector. This is a feasibility problem wherein it finds a point that satisfies the constraints. As we can see, the constraints are not convex and non-continuous that it turns the problem to be *NP-hard*. To overcome this issue, the inventors replace the condition with its convex relaxation as follows (11)

$$\mathcal{P}_2 = find \qquad\qquad \mathbf{x}$$
$$s.t. \qquad\qquad |s_i - s_j|^2 \geq \mathcal{E}|f_i - f_j|^2,$$
$$\forall (i,j) \in [M] \times [M],$$

where $\varepsilon > 0$ is a positive constant. The inventors have shown that for a enough large $\varepsilon$ Problem $\mathcal{P}_1$ can be equal to $\mathcal{P}_2$. Therefore, the inventors can deduce that these two problems are equal to each other. Since there is no assumption on the amplitude of variable $\mathbf{x}$, the constant $\varepsilon$ can be absorbed by $\mathbf{x}$ and we drop it from optimization problem $\mathcal{P}_1$, accordingly. To determine whether the constraints are consistent, and if so, find a point that satisfies them, we have the following lemma.

Lemma 1: Let $\lambda_{i,j}$s for $(i,j) \in [M] \times [M]$ be the Lagrangian multipliers corresponding to the constraints of optimization problem i.e. $\mathcal{P}_2$. Then, the problem $\mathcal{P}_2$ is feasible if and only if

$$\sum_{j \neq i,j} \sum_i \lambda_{i,j} \mathbf{B}_{i,j} \mathbf{x} = \mathbf{0}$$

$$\lambda_{i,j} = 0, \quad \Rightarrow |f_i - f_j|^2 \leq |s_i - s_j|^2$$

$$\lambda_{i,j} > 0, \quad \Rightarrow |f_i - f_j|^2 = |s_i - s_j|^2,$$

where $\mathbf{B}_{i,j} = (\mathbf{a}_i - \mathbf{a}_j)(\mathbf{a}_i - \mathbf{a}_j)^\mathsf{T}$ and $\mathbf{a}_i$ denotes i-th rows of matrix $\mathbf{A}$. Indeed, the Lagrangian multipliers of optimization in $\mathcal{P}_2$ is built as below (15)

$$\mathcal{L} = \sum_{j \neq i,j} \sum_i \lambda_{i,j} \underbrace{\left( -|s_i - s_j|^2 + |f_i - f_j|^2 \right)}_{\tilde{g}_{i,j}}.$$

Since the constraint are convex and differentiable, from KKT conditions, the inventors know that the feasible points must satisfy the following conditions (16)

$$\sum_{j \neq i,j} \sum_i \lambda_{i,j} \nabla g_{i,j} = \mathbf{0}$$

$$\lambda_{i,j} = 0, \quad \Rightarrow g_{i,j} \leq 0$$

$$\lambda_{i,j} > 0, \quad \Rightarrow g_{i,j} = 0,$$

where $\nabla g_{i,j}$ is the gradient respect to x i.e.(19)

$$\nabla g_{i,j} = \underbrace{-2(\mathbf{a}_i - \mathbf{a}_j)(\mathbf{a}_i - \mathbf{a}_j)^{\mathsf{T}}}_{\mathbf{B}_{i,j}} \mathbf{x},$$

in which $\mathbf{a}_i$ denotes i-th rows of matrix $\mathbf{A}$. By substituting (19) in (16), it gives us

$$\sum_{j \neq i,j} \sum_i \lambda_{i,j} \mathbf{B}_{i,j} \mathbf{x} = \mathbf{0}$$

$$\lambda_{i,j} = 0, \quad \Rightarrow \left| f_i - f_j \right|^2 \leq \left| s_i - s_j \right|^2$$

$$\lambda_{i,j} > 0, \quad \Rightarrow \left| f_i - f_j \right|^2 = \left| s_i - s_j \right|^2,$$

for $i \neq j$. Therefore, giving the modulation vector $\mathbf{x}$, yhe inventors can obtain the conditions under which function $f$ can be computed perfectly. In what follows, we solved conditions in (16) for standard modulations such as BPSK and QPSK for class of linear functions.

*Linear Functions*

In this subsection, the inventors used the *KKT* conditions for a linear function to provide guarantee in which linear functions can be compute for a certain modulation. A linear function $f: \mathbb{R}^K \mapsto \mathbb{R}$ is defined

$$f(x_1, \ldots, x_k) = \sum_{k=1}^{K} a_k x_k + c,$$

where $a_1, \ldots, a_K$ and $c$ are real constant numbers. Here, the inventors aim at determining the constraints for the case of linear functions in two different scenarios where all the users using same modulations or different modulations. We first solve KKT condition (16) for a linear function $f$ with binary domain i.e. $q = 1$ where users using BPSK modulation for their communication. Then, the invenrors repeat the analyze for the case in which each node has different modulations. Finally, the inventors extend the results for the $K$ user with arbitrary modulation order $q \geq 1$.

*Binary domain bi-variable function with BPSK*

Let the desired function be $f(x_1,x_2) = a_1x_1 + a_2x_2 + c$ where $x_1,x_2 \in \{0,1\}$ and their corresponding modulation signals $\vec{x}_1, \vec{x}_2$ are set to be BPSK. We can see the range of the function includes $R_f = f_1,f_2,f_3,f_4$ where the values of $f_1, f_2, f_3$ and $f_4$ are equal to 0, $a_1, a_2, a_1 + a_2$, respectively. Utilizing BPSK modulation for both users equals to set vector $\mathbf{x}$ to be [b, -b, b, -b]$^{\mathsf{T}}$ where $b \in \mathbb{R}$ is a nonzero real number denotes amplitude for transmitting data which is the same for all the users here. Then, by putting the modulation vector $\mathbf{x}$ into (15), it gives us the following cost function in term of $b$ and $\lambda_i$s

$$\mathcal{L} = \lambda_{1,2}(2b)^2 + \lambda_{1,3}(2b)^2 + \lambda_{1,4}(4b)^2 + \lambda_{2,3} \times 0 + \lambda_{2,4}(-2b)^2 + \lambda_{3,4}(-2b)^2.$$

Next, by setting its derivative respect to $b$ to be zero i.e. $\frac{\partial \mathcal{L}}{\partial b} = 0$, we have

$$-8\big(\lambda_{1,2} + \lambda_{1,3} + 4\lambda_{1,4} + \lambda_{2,4} + \lambda_{3,4}\big)b = 0$$

Hence, $b \neq 0$ is a nonzero real number and all Lagrangian multipliers are non-negative, we can directly conclude that all $\lambda_{1,2} = \lambda_{1,4} = \lambda_{3,4} = \lambda_{2,4} = \lambda_{1,3} = 0$ expect $\lambda_{2,3} > 0$.

Then, the inventors know the Lagrangian multipliers for the next KKT conditions in (16) it needs absolute value of $b$ be greater than $|a_1|$ and $|a_2|$ i.e.

$$|b| \geq \frac{\max\{|a_1|, |a_2|\}}{2}.$$

Also, for the condition corresponding to $\lambda_{2,3}$, the inventors need to check the last KKT condition in (16) that it leads to

$$a_1 = a_2.$$

This is not valid in general. In other words, by using same BPSK modulation, one can not compute a linear function unless its coefficients have same value which is not enough general model.

*bi-variable function with different modulation*

Here, we use different modulations for each user i.e. **x** = [$b$, $-b$, $d$, $-d$] in which $d, b \in \mathbb{R}$. It should be noted that this model for BPSK is general enough to include arbitrary one bit modulation because of symmetry of two points in a 2-D space.

Proposition 3: For a bi-variable function $f(x_1, x_2) = a_1 x_1 + a_2 x_2$ where $x_1, x_2 \in \{0,1\}$ and $a_1, a_2 \in \mathbb{R}$, we can compute the function over the air using BPSK modulation for two users with amplitudes $d, b \in \mathbb{R}$ or equivalently **x** = [$b$, $-b$, $d$, $-d$], if and only if there exist an $\varepsilon > 0$ such that

$$|b| \geq \sqrt{\varepsilon}\frac{|a_1|}{2},$$

$$|d - b| \geq \sqrt{\varepsilon}\frac{|a_1 - a_2|}{2}.$$

At this time, the first condition gives

$$\frac{\partial \mathcal{L}}{\partial b} = b\big(\lambda_{1,2} + \lambda_{1,4} + \lambda_{2,3} + \lambda_{3,4}\big) + d\big(\lambda_{1,4} - \lambda_{2,3}\big) = 0,$$

$$\frac{\partial \mathcal{L}}{\partial d} = d\big(\lambda_{1,3} + \lambda_{1,4} + \lambda_{2,3} + \lambda_{2,4}\big) + b\big(\lambda_{1,4} - \lambda_{2,3}\big) = 0,$$

By rearranging the coefficients of the equations, we have

$$(b - d)\lambda_{2,3} + (b + d)\lambda_{1,4} + b\big(\lambda_{1,2} + \lambda_{3,4}\big) = 0$$

$$(d - b)\lambda_{2,3} + (b + d)\lambda_{1,4} + d(\lambda_{1,3} + \lambda_{2,4}) = 0 \quad .$$

Here, the inventors can see that either *b > d* or *d > b* in both cases, these equations enforces all of the Lagrangian multipliers $\lambda_{1,2} = \lambda_{1,4} = \lambda_{3,4} = \lambda_{2,4} = \lambda_{1,3} = \lambda_{2,3} = 0$ to be zero which means all constraints are feasible. In particular, the function *f* can be computed if

$$|b| \geq \frac{|a_1|}{2},$$

$$|d - b| \geq \frac{|a_1 - a_2|}{2},$$

Next, by following similar steps for QPSK modulation
it yields the condition under which function f would be computed as follows

$$|b_1| \geq \frac{|a_1|}{2},$$

$$|b_2 - b_1| \geq \frac{|a_1 - a_2|}{2},$$

In what follows, the inventors extent the conditions for the general case of a linear function.

*K different modulation with different $q_k$ bits*

To extend the obtained results for the K different modulation, the inventors express modulation vector of the *k*-th user with q symbols by $\mathbf{x}_k = \left[b_{k,1}, b_{k,2}, \ldots, b_{k,q}\right]^{\mathsf{T}} \in \mathbb{C}^q$ . In this case, the output of function are totally not equal to each other i.e. $f_i \neq f_j$ for all possible (*i, j*) except *i = j.*

Proposition 4: For a *K* multi-variable function $f(x_1, \ldots, x_k) = \sum_{k=1}^{K} a_k x_k + c$ where $x_k \in \{0, \ldots, q\text{ - }1\}$ and $a_k \in \mathbb{R}$ for *k* ∈ [*K*], one can compute the function over the air using modulation vector $\vec{x}_k = d_k\left[b_1, b_2, \ldots, b_q\right]^{\mathsf{T}} \in \mathbb{C}^q$ if and only if there exist $\varepsilon$ > 0 such that (40)

$$|\sum_{k=1}^{K} d_k\left(b_{\ell_k} - b_{r_k}\right)| \geq \sqrt{\varepsilon}|\sum_{k=1}^{K} a_k\left(x_{\ell_k} - x_{r_k}\right)|,$$

for all $(\ell_k, r_k) \in [q] \times [q]$ and *k* = [*K*].
Based on Proposition 4, modulation vector $\mathbf{x}_k$ needs to satisfy $q^K$ conditions for computing linear functions. However, one can see that for linear functions if one sets

$$d_k = \alpha a_k, \quad and, \quad b_r = x_r,$$

for *k* ∈ [*K*], *r* ∈ [*q*], and an arbitrary complex number $\alpha \in \mathbb{C}$ such that $|\alpha| \geq \sqrt{\varepsilon}$ , then all the constraints in (40) would be accordingly fulfilled. Moreover, by choosing elements of $\mathbf{x}_k$ from (40) for $\alpha = \sqrt{\varepsilon}$,, the cost function $\mathcal{L}$ may equal to zero.

*ChannelComp over AWGN Channels*

In this section, one may consider a more realistic scenario where the channel coefficients are not ideal and the received data are polluted by Gaussian noise. The communication network is considered to be known and deterministic channels (i.e. prefect CSI), which restricts the applicability of the results to applications with known CSI. We also assumed that we have access to the prefect CSI at each time slot.

Consequently, the measured signals at CP read to

$$\vec{y}_n(t) = \sum_{k \in [K]} h_k(t)\vec{x}_k(t) + z(t).$$

Here, $h_k(t)$ is the known channel coefficient form k-th device to CP and $\mathbf{z} \in \mathbb{C}$ denotes AWGN noise with variance $\sigma_z^2$. To alleviate the notation, let define vector $\mathbf{h} := [h_1, \dots, h_K]^\top \in \mathbb{C}^K$. Also, we need to define operator $\mathcal{H}_q : \mathbb{C}^K \mapsto \mathbb{C}^{N \times N}$ as follows

$$\mathcal{H}_q(\mathbf{h}) := diag(\mathbf{h}) \otimes \mathbf{I}_q = diag(h_1 \mathbf{I}_q, \dots, h_K \mathbf{I}_q),$$

where $\otimes$ denotes Kronecker product and $\mathbf{I}_q$ represent $q \times q$ identity matrix. To alleviate the notation, we drop the sub index $q$. Then, the constellation points can be represented as

$$\mathbf{A}\mathcal{H}(\mathbf{h})\mathbf{x} = \tilde{\mathbf{s}},$$

where $\tilde{\mathbf{s}} = [\tilde{s}_1, \tilde{s}_2, \dots, \tilde{s}_M]^\top \in \mathbb{C}^M$ denotes constellation points in the presence of fading. In this scenario, we can observe $\tilde{s}_i = \mathbf{a}_i^\top \mathcal{H}(\mathbf{h})\mathbf{x}$.

Since there exist noise in the channel, performance of computation network would be degraded by polluted signals $\vec{x}_k$s which leads to the computation error. In addition, one need to ensure that received signals satisfy a minimum signal to noise ratio (SNR) constraint for providing a reliable communication. Therefore, the following constraints need to be taken into account (48)

$$|s_i - s_j|^2 \geq |f_i - f_j|^2,$$

$$\frac{|s_i - s_j|^2}{\sigma_z^2} \geq \gamma_0.$$

Here, the first condition in (48) control the computation. Since all the values in both sides of the equations (48) are positive, one consequence is the distance between each pair of the constellation points to be greater than product of both right side of them i.e. $|s_i - s_j|^2 \geq \sigma_z^2 \gamma_0 |f_i - f_j|^2$ for all (*i,j*). Accordingly, by incorporating the constraints, the inventors may propose the following optimization problem to find an appropriate modulation vector **x** for the communication and computation (50).

$$\hat{\mathbf{x}} = \underset{\mathbf{x}}{arg\,min} \quad \| \mathbf{x} \|_2^2$$

$$s.t. \quad |(\mathbf{a}_i - \mathbf{a}_j)^\top \mathcal{H}(\mathbf{h})\mathbf{x}|^2 \geq \gamma_0 \sigma_z^2 |f_i - f_j|^2,$$

for all (*i,j*) ∈ [M] × [M], *i ≠ j*. This problem is a quadratically constrained quadratic programming (QCQP) problem, but unfortunately the constraints are not convex. Non-convexity does not mean that the problem is difficult to solve; Nevertheless, this problem is a *NP-hard* problem . Toward solving this issue, the inventors use *lifting trick* in which the inventors first recast the cost function as bellow

$$\hat{\mathbf{x}} = \underset{\mathbf{x}}{arg\,min} \quad Tr(\mathbf{x}\mathbf{x}^\mathsf{H})$$

$$s.t. \quad Tr(\mathbf{x}\mathbf{x}^\mathsf{H}\tilde{\mathbf{B}}_{i,j}) \geq \tilde{f}_{i,j},$$

where $\tilde{f}_{i,j} = \varepsilon^{-1}|f_i - f_j|^2$ for all $(i,j) \in \mathcal{M}^2$, $i \neq j$ and $\tilde{\mathbf{B}}_{i,j} = \mathcal{H}(\mathbf{h})^{\mathsf{T}}(\mathbf{a}_i - \mathbf{a}_j)(\mathbf{a}_i - \mathbf{a}_j)^{\mathsf{T}} \mathcal{H}(\mathbf{h})$. Now, if one treats $\mathbf{xx}^{\mathsf{H}}$ as a matrix like $\mathbf{X} \in \mathbb{C}^{N \times N}$, then the problem may be reformulated as

$$\hat{\mathbf{X}} = \underset{\mathbf{X}}{arg\,min} \qquad Tr(\mathbf{X})$$
$$s.\,t. \qquad \langle \mathbf{X}, \tilde{\mathbf{B}}_{i,j} \rangle \geq \tilde{f}_{i,j},$$
$$\mathbf{X} \succeq \mathbf{0}, \quad rank(\mathbf{X}) = 1,$$

in which the inequality $\mathbf{X} \succeq 0$ means that the matrix $\mathbf{X}$ is symmetric positive semi-definite and $\langle \mathbf{X}, \tilde{\mathbf{B}}_{i,j} \rangle$ represents matrix inner product i.e. $Tr(\mathbf{X}\tilde{\mathbf{B}}_{i,j}^{\mathsf{T}})$. This is linear and convex problem respect to matrix $\mathbf{X}$ except about the rank constraint. One possible way to handle this issue is to relax the problem by dropping the rank-one constraint from the optimization which leads to

$$\hat{\mathbf{X}} = \underset{\mathbf{X}}{arg\,min} \qquad Tr(\mathbf{X})$$
$$s.\,t. \qquad \langle \mathbf{X}, \tilde{\mathbf{B}}_{i,j} \rangle \geq \tilde{f}_{i,j},$$
$$\mathbf{X} \succeq \mathbf{0}.$$

which is a SDP problem, and it can be efficiently solved by using CVX. Afterwards, the optimal modulation vector $\mathbf{x}$ solution to the original problem can be obtained via Cholesky decomposition of $\mathbf{X}^*$ unless the solution to the SDP problem becomes a rank one matrix; otherwise, as a sub-optimal solution to the original problem, one can use the Gaussian randomization method. Nevertheless, the solution of the relaxed problem oftentimes does not meet the rank-one constraint and is a sub-optimal, especially for cases wherein the dimension of the optimization variables becomes large i.e. $N \gg 1$. To overcome the mentioned drawback, the rank-one constraint may be replaced by another equivalent function which would be successively solved using the primal and dual problems thereof. Particularly, the inventors have the representation in the following Lemma for the rank-one constraint.

Proposition 6: For a PSD matrix $\mathbf{X} \in \mathbb{C}^{N \times N}$ with $Tr(\mathbf{X}) > 0$, we have

$$rank(\mathbf{X}) = 1 \quad \Leftrightarrow \quad Tr(\mathbf{X}) - \| \mathbf{X} \|_2 = 0,$$

where $\|.\|_2$ denotes spectral norm.

As a result, the inventors may replace rank one constraint with the penalty term in the Proposition 6 as follows

$$\hat{\mathbf{X}} = \underset{\mathbf{X}}{arg\,min} \qquad Tr(\mathbf{X}) + \rho(Tr(\mathbf{X}) - \| \mathbf{X} \|_2)$$
$$s.\,t. \qquad \langle \mathbf{X}, \tilde{\mathbf{B}}_{i,j} \rangle \geq \tilde{f}_{i,j},$$
$$\mathbf{X} \succeq \mathbf{0}.$$

where $\rho > 0$ is the penalty parameter. As the aforementioned problem is still non-convex, the optimization can be solved using difference-of-convex (DC) programming algorithm.

*Computation with Minimizing Maximum Error*

Another interesting approach to have a reliable computation or equivalently computation with minimum error is to minimize the maximum error coming from detection. Particularly, let $P_{i,j}$ be probability of the error of computing $f_j$ instead of $f_i$, then, the computation error can be defined as $E_{i,j} := P_{i,j}|f_i - f_j|$. As a result, one can solve the following optimization problem

$$\hat{\mathbf{x}} = \underset{\mathbf{x}}{arg\,min}\,\underset{i,j}{max} \qquad P_{i,j}|f_i - f_j|$$
$$s.\,t. \qquad \| \mathbf{x} \|_2^2 \leq P,$$

where the last condition is the maximum available power budget for the communication. Also, it has been assumed that all constellation symbols are selected for transmission with equal probability. We can see this problem is too complicated to be solved. One possible approximation solution is to employ union bound of the probability of the error $P_{i,j}$ i.e.

$$P_{i,j} \leq Q\left(\sqrt{\frac{\left|(\mathbf{a}_i - \mathbf{a}_j)^\top \mathbf{x}\right|^2}{2\sigma_z}}\right),$$ as a surrogate function to replace a simple upper bound with the complex cost function.

The rationale is that as the Q-function decrease, the probability of error $P_{i,j}$ shall also diminish. However, working with Q function is still difficult, one well-known way to upper bound the Gaussian Q-function is to use the Chernoff upper bound i.e.

$$Q(x) \leq \frac{e^{-x^2/2}}{2}$$ accordingly. More accurate approximations than the Chernoff bound is also proposed as Chiani bound.

However, in our optimization problem, Chiani bound can make the problem more complicated. Hence, using Chernoff bound, the objective function reads to

$$\hat{\mathbf{x}} = \underset{\mathbf{x}}{arg\,min}\,\underset{i,j}{\max}\quad \exp\left(-\frac{\left|(\mathbf{a}_i - \mathbf{a}_j)^\top \mathcal{H}(\mathbf{h})\mathbf{x}\right|^2}{4\sigma_z}\right)\frac{|f_i - f_j|}{2}$$

$$s.t. \quad \|\mathbf{x}\|_2^2 \leq P,$$

Next, by taking the logarithm of the objective function and taking out mines thereof, one could reach to

$$\hat{\mathbf{x}} = \underset{\mathbf{x}}{arg\,max}\,\underset{i,j}{\min}\quad \frac{\mathbf{x}^\top \widetilde{\mathbf{B}}_{i,j}\mathbf{x}}{4\sigma_z} - \log\left(\frac{|f_i - f_j|}{2}\right)$$

$$s.t. \quad \|\mathbf{x}\|_2^2 \leq P,$$

This problem special class of non-convex QCQP problems is a non-smooth, non-convex optimization problem due to the fact that the point-wise minimum of convex quadratics is non-differentiable and non-concave. For solving this problem, one can use successive convex approximation (SCA) method . In particular, the inventors iteratively approximate the primal non-convex problem by a sequence of convex problem. A feasible point $\mathbf{x}^{(0)}$ is picked as a starting point, then the algorithm proceeds by minimizing a convex majorization function of the non-convex cost function. Now, let us define the function $\upsilon_\mu(\mathbf{x}, \mathbf{x}^{(t)})$ as follows

$$\upsilon_\mu\left(\mathbf{x}, \mathbf{x}^{(t)}\right) := \log\left(\sum_{i,j}^M \exp\left(\frac{\mathbf{c}_{i,j}^{(t)\mathsf{H}}\mathbf{x} + \mathbf{d}_{i,j}^{(t)}}{\mu}\right)\right),$$

where $\mathbf{c}_{i,j}^{(t)} = 2\widetilde{\mathbf{B}}_{i,j}\mathbf{x}^{(t-1)}$, and $\mathbf{d}_{i,j}^{(t)} = \mathbf{x}^{(t-1)\mathsf{H}}\widetilde{\mathbf{B}}_{i,j}\mathbf{x}^{(t-1)} - \log\left(|f_i - f_j|/2\right)$. Then, at each iteration we would solve the following optimization

$$\underset{\mathbf{x}}{\min}\quad \upsilon_\mu\left(\mathbf{x}, \mathbf{c}_{i,j}^{(t)}, \mathbf{d}_{i,j}^{(t)}\right)$$

$$s.t. \quad \|\mathbf{x}\|_2^2 \leq P,$$

Since it is a smooth optimization problem, accordingly, it can be solved using an accelerated first order method like Nesterov's smoothing technique. The overall SCA procedure may be implemented in an Algorithm.

*Computation with Minimizing Average Error*

On the other hand, minimizing computation error can be implemented through minimizing the average error coming from detection. Particularly, for probability of the error of computing $f_j$ instead of $f_i$, one can solve the following optimization problem

$$\hat{\mathbf{x}} = \underset{\mathbf{x}}{arg\,min} \qquad \sum_i^M \pi_i \sum_{j=1}^M P_{i,j} \left| f_i - f_j \right|^2$$

$$s.\,t. \qquad \parallel \mathbf{x} \parallel_2^2 \leq P,$$

where $\pi_i$ represents the probability of transmitting signal to compute $f_i$. Similar to the previous optimization problem, the inventors are able to approximate the probabilities of error using an upper bound which allows us to culminate into a convex optimization problem as follows:

$$\hat{\mathbf{x}} = \underset{\mathbf{x}}{arg\,min} \qquad \sum_i^M \pi_i \sum_{j=1}^M e^{\left( -\frac{\left| (\mathbf{a}_i - \mathbf{a}_j)^\top \mathcal{H}(\mathbf{h})\mathbf{x} \right|^2}{4\sigma_z} \right)} \left| f_i - f_j \right|^2$$

$$s.\,t. \qquad \parallel \mathbf{x} \parallel_2^2 \leq P,$$

Here, we again use lifting trick by defining $\mathbf{X} = \mathbf{x}\mathbf{x}^\top$ and $\tilde{\mathbf{B}}_{i,j} = (\mathbf{a}_i - \mathbf{a}_j)(\mathbf{a}_i - \mathbf{a}_j)^\top$. After substituting the variables, the optimization problem therefore is given in following (63)

$$\hat{\mathbf{X}} = \underset{\mathbf{X}}{arg\,min} \qquad \sum_i^M \pi_i \sum_{j=1}^M \exp\left( -\frac{\langle \mathbf{X}, \tilde{\mathbf{B}}_{i,j} \rangle}{4\sigma_z} \right) \left| f_i - f_j \right|^2$$

$$s.\,t. \qquad \langle \mathbf{X}, \mathbf{I} \rangle \leq P, \quad \mathbf{X} \succcurlyeq 0$$

where $rank(\mathbf{X}) = 1$ constraint has been dropped as a relaxation step.

Proposition 7: the optimization problem in (63) is convex in $\mathbf{X} \succcurlyeq \mathbf{0}$.

*Proof.* Since $\tilde{\mathbf{B}}_{i,j} \succcurlyeq \mathbf{0}$ is a positive semi-definite matrix for $(i,j) \in [M] \times [M]$, we have that:

$$\frac{\partial \exp\left( -\frac{\langle \mathbf{X}, \tilde{\mathbf{B}}_{i,j} \rangle}{4\sigma_z} \right)}{\partial \mathbf{X}} = -\frac{\tilde{\mathbf{B}}_{i,j}}{4\sigma_z} \exp\left( -\frac{\langle \mathbf{X}, \tilde{\mathbf{B}}_{i,j} \rangle}{4\sigma_z} \right) \preccurlyeq \mathbf{0},$$

$$\frac{\partial^2 \exp\left( -\frac{\langle \mathbf{X}, \tilde{\mathbf{B}}_{i,j} \rangle}{4\sigma_z} \right)}{\partial \mathbf{X}^2} = \frac{\tilde{\mathbf{B}}_{i,j}^2}{16\sigma_z^2} \exp\left( -\frac{\langle \mathbf{X}, \tilde{\mathbf{B}}_{i,j} \rangle}{4\sigma_z} \right) \succcurlyeq \mathbf{0}.$$

Since the convexity is preserved under an affine transformation, the objective function in (63) is accordingly a convex function (48). □

It is well known that a convex optimization problem can be solved by using interior point methods which require polynomial complexity. Utilizing log barrier method is a standard method to solve the optimization in (63).

*Stochastic Fading Channel*

The nodes usually can estimate the channel coefficients $h_k$s and use the estimation as imperfect value to perform the communication. However, there exist scenarios where one is not able to estimate the channel. In this case, by modeling the physical model of communication, the nodes can obtain a distribution for the channel. One well-known stochastic model for radio propagation is to consider Rician distribution for the channel. The Rician fading typically occurs when one of the paths, a line of sight signal is much stronger than the others. Without line of sight signal, it can be shown that the distribution would be reduced to Rayleigh fading.

Since channel coefficients $h_k$s are no longer deterministic, accordingly, the mentioned minimization problems become random optimization. To perform Digital ChannelComp, one possible solution is to replace the computation condition by its expectation respect to $h_k$s i.e. the computation condition would read to

$$\mathbb{E}\left[\left|\left(\mathbf{a}_i - \mathbf{a}_j\right)^{\top}\mathcal{H}(\mathbf{h})\mathbf{x}\right|^2\right] \geq \gamma_0 \sigma_z^2 \left|f_i - f_j\right|^2$$

$$\left(\mathbf{a}_i - \mathbf{a}_j\right)^{\top}\mathbf{C}_h\left(\mathbf{a}_i - \mathbf{a}_j\right) \geq \gamma_0 \sigma_z^2 \left|f_i - f_j\right|^2$$

where

$$
\begin{aligned}
C_h &= \mathbb{E}[\mathcal{H}(\mathbf{h})\mathbf{x}\mathbf{x}^{\top}\mathcal{H}(\mathbf{h})] \\
&= \mathbb{E}\left[\left(\mathbf{h}\mathbf{h}^{\mathsf{H}} \otimes \mathbf{I}_q\right) \odot \mathbf{x}\mathbf{x}^{\top}\right] \\
&= \left(\mathbb{E}[\mathbf{h}\mathbf{h}^{\mathsf{H}}] \otimes \mathbf{I}_q\right) \odot \mathbf{x}\mathbf{x}^{\top},
\end{aligned}
$$

where $\odot$ indicates Hadamard product. Next, for $\mathbb{E}[\mathbf{h}\mathbf{h}^{\mathsf{H}}]$, we have

$$
\mathbb{E}[\mathbf{h}\mathbf{h}^{\mathsf{H}}] = \begin{bmatrix}
\sigma_{h_1}^2 & \mu_{h_1}\mu_{h_2} & \cdots & \mu_{h_1}\mu_{h_K} \\
\mu_{h_2}\mu_{h_1} & \sigma_{h_2}^2 & \cdots & \mu_{h_2}\mu_{h_K} \\
\vdots & \vdots & \cdots & \vdots \\
\mu_{h_K}\mu_{h_1} & \cdots & \cdots & \sigma_{h_K}^2
\end{bmatrix}
$$

in which $\mu_{h_K}$ and $\sigma_{h_k}^2$ are the mean and variance of the distribution of $h_k$, respectively. Therefore, the inventors replace channel coefficients by their available mean from the distribution and then through same optimization can be determined the modulation. Note that in this case, the solution of the optimization is also valid in expectation and the computed value for the function $f$ are not always correct, accordingly.

*MIMO Digital Computation For Matrix Calculation*

In the previous sections, the existing solutions focus only on single-function AirComp, assuming there exists a single antenna on each node. However, in the next generation of wireless networks, the nodes equipped with large-scale arrays will provide the possibility of computing multiple functions of multi-data AirComp, simultaneously. This inspires us to extend the previous optimization for a multi-input multi-output (MIMO) MAC in which we have multi-function computation. We reconsider a wireless network consisting of $K$ multi-nodes and a single receiver CP. Particularly, each node uses $N_t$ antennas for transmitting data and $N_r$ antenna existed at CP.

The MIMO structure can be effective on both improvement of the computation rate or decreasing the distortion. Others have developed a MIMO setup for AirComp using beam-forming techniques in analog modulation. Moreover, they designed beam-forming to minimize the mean square error (MSE) criterion to remove resultant distortion by the AWGN noise and the fading. Here, the inventors instead aim to utilize the channel state information to design constellation points so that the inventors can satisfy the computation constraints.

In the following subsection, the inventors have discussed two possible different scenarios for MIMO of the DiChComp.

*MIMO for improving distortion*

For the first setup, we aim to decreasing only noise effect by using beam-former for compute a desire function $\mathbf{f}(x_1, \ldots, x_K)\colon \mathbb{R}^K \mapsto \mathbb{R}^L$ with $L$ output ($L$ must be lower than number of receiver antenna i.e. $L \leq N_r$). In the note worthy case $L = 1$, the computation problem would be reduced to the previous scalar function problem. Therefore, the computation problem is extended to a vector function instead of a scalar function together with using beam-formers at transmitters and receivers to decrease distortion. To illustrate, consider the following systems of linear equations as an example of desired function $\mathbf{f}$ for an input vector $\mathbf{x} \in \mathbb{R}^K$

$$\mathbf{f}(\mathbf{x}) = \mathbf{A}\mathbf{x} + \mathbf{b},$$

where $\mathbf{A} \in \mathbb{R}^{L \times K}$ and $\mathbf{b} \in \mathbb{R}^L$. Here, *i*-th element of the input vector i.e. $x_i$ can correspond to data of i-th node for $i \in [K]$; *j*-

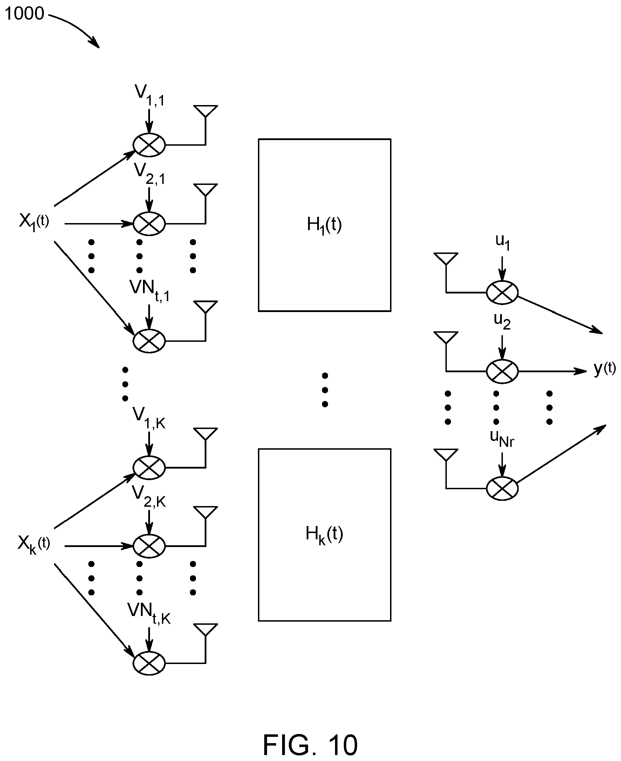

th element of the out put vector i.e. $[\mathbf{f}]_j$ corresponds to the received data by $j$-th antenna at receiver, accordingly. Assuming symbol-level synchronization, all users transmit their symbol vectors simultaneously using their arrays. The distortion of the received vector concerning the target function vector due to MIMO channels and noise is suppressed using transmit and receive beam-forming. In other words, the joint beam-forming attempts to attain coherent combining of $K$ symbol vectors at the CP. Particularly, let $\mathbf{V}_k \in \mathbb{C}^{N_t \times 1}$ is the transmit beam-forming vector at sensor $k$ and $\mathbf{U} \in \mathbb{C}^{N_r \times L}$ denotes the receive beam-forming matrix (see Fig. 10). Then, the measured signals received by CP over MAC at time t is (73)

$$\vec{\mathbf{y}}_n(t) = \mathbf{U}^{\mathsf{H}}\left( \sum_{k \in [K]} \mathbf{H}_k(t)\mathbf{v}_k \vec{x}_k(t) + \mathbf{Z}(t) \right),$$

where $\mathbf{Z}(t) \in \mathbb{C}^{N_r \times 1}$ denotes the AWGN vector with independent and identically distributed (i.i.d.) $\mathcal{N}(0, \sigma_z \mathbf{I}_{N_r \times N_r})$. Next, let $\mathbf{X}_k \in \mathbb{C}^q$ be the modulation vector of signal $\vec{x}_k$ and vector $\mathbf{c}_k \in \mathbb{C}^{N_t q \times 1}$ be the Kronecker product of two vectors $\mathbf{v}_k$ and $\mathbf{x}_k$ i.e. $\mathbf{c}_k := \mathbf{x}_k \otimes \mathbf{v}_k$. In addition, for the channel coefficients between transmitters and receivers, we have the following $NN_r \times NN_t$ complex matrix

$$\mathcal{BH} := diag\left( \left[ \mathbf{I}_{q \times q} \otimes \mathbf{H}_1, \ldots, \mathbf{I}_{q \times q} \otimes \mathbf{H}_K \right] \right),$$

where $\otimes$ denotes the Kronecker product. We further define $\mathbf{C} = \left[ \mathbf{c}_1, \ldots, \mathbf{c}_K \right]^{\mathsf{T}} \in \mathbb{C}^{NN_t \times 1}$, and $\tilde{\mathbf{A}} = \mathbf{A} \otimes \mathbf{I}_{N_r \times N_r}$, which is a $MN_r \times NN_r$ matrix, $\mathcal{U} = \mathbf{I}_{M \times M} \otimes \mathbf{U} \in \mathbb{C}^{MN_r \times ML}$. Hence, for the constellation points, we have

$$\mathcal{U}^{\mathsf{H}} \tilde{\mathbf{A}} \mathcal{BH} \mathbf{C} = \mathbf{S}$$

where $\mathbf{S} \in \mathbb{C}^{M \times L}$. For sake of simplicity, we decompose the $\mathbf{C}$ as $X\mathbf{v}$ where $\mathbf{V} = \left[ \mathbf{v}_1, \ldots, \mathbf{v}_K \right]^{\mathsf{T}} \in \mathbb{C}^{N_t K \times 1}$ and $X := diag([\mathcal{K}_{N_t}(\mathbf{x}_1), \ldots, \mathcal{K}_{N_t}(\mathbf{x}_k)])$ in which $\mathcal{K}_{N_t}$ is an linear operator which for a vector $\mathbf{a} \in \mathbb{C}^q$ is defined as

$$\mathcal{K}_{N_t}(\mathbf{a}) := \left[ a_1 \mathbf{I}_{N_t \times N_t} \ldots, a_N \mathbf{I}_{N_t \times N_t} \right]^{\mathsf{T}} \in \mathbb{C}^{N_t q \times N_t},$$

where $a_i$ denotes $i$-th element of vector a. For computing the vector function $\mathbf{f} \in \mathbb{R}^L$, the computation condition in (10) needs to be modified, consequently. We bring this condition in the form of the following proposition.

Proposition 8: Let $\mathbf{f}_i \in \mathbb{R}^L$ be the $i$-th output of the function for a certain value of input $x_1, x_2, \ldots, x_k$ from $[M^L]$ possible values of the function $\mathbf{f}$ and also, $\mathbf{s}_i \in \mathbb{C}^L$ represents the corresponding $L$ constellation points. Then, the computation is valid if and only if when we have the following

$$if \quad \mathbf{f}_i \neq \mathbf{f}_j \ \Rightarrow \mathbf{s}_i \neq \mathbf{s}_j,$$

where $\mathbf{s}_i$ denotes i-th rows of matrix $\mathbf{S}$.

We suggest a similar relaxation to (11) for the mentioned condition in Proposition (8) which leads to following feasibility problem

$$\mathcal{P}_{M-feas} = find \quad \quad \mathbf{v}, \mathbf{U}$$
$$s.t. \quad \quad \| \mathbf{s}_i - \mathbf{s}_j \|_2^2 \geq \mathcal{E} \| \mathbf{f}_i - \mathbf{f}_j \|_2^2,$$
$$\forall (i, j) \in [M^L] \times [M^L],$$

As a result, in the MIMO scenario, using the aforementioned condition and matrix notation, one can reformulate the optimization in (50) for a given set of modulation vectors $\{\mathbf{x}_k\}_{k=1}^K$ as follows

$$\hat{v}, \hat{U} = \arg\min_{v, U} \left\| v \right\|_2^2$$

$$\text{s.t.} \quad \left\| U^H (\tilde{A}_i - \tilde{A}_j) \mathcal{B}\mathcal{H}\mathcal{X} v \right\|_2^2 \geq \gamma_0 \sigma_z^2 \left\| f_i - f_j \right\|_2^2$$

where $\tilde{A}_i$ denotes i-th block matrix of size $N_r \times NN_r$ of matrix $\tilde{A}$. Similarly, the other optimizations can be addressed as follows (79)

$$\hat{v}, \hat{U} = \underset{v, U}{argmax} \min_{i,j} \quad \sum_k \frac{v_k^\mathsf{T} C_{i,j} v_k}{4\sigma_z} - \log\left(\frac{\| f_i - f_j \|_2}{2}\right)$$

$$s.t. \quad \| v_k \|_2^2 \leq P_k,$$

where

$$C_{i,j} = \mathcal{X}^H \mathcal{B}\mathcal{H}^H (\tilde{A}_i - \tilde{A}_j)^H U U^H (\tilde{A}_i - \tilde{A}_j) \mathcal{B}\mathcal{H}\mathcal{X},$$

and $P_k$ denotes allocated power budget for node $k$. Similarly, for minimizing the average error we have that

$$\hat{V}, \hat{U} = \underset{V, U}{argmin} \sum_{i=1}^M \sum_{j=1}^M \exp\left(-\frac{\langle V, \widetilde{C_{i,j}}\rangle}{4\sigma_z}\right) \left\| f_i - f_j \right\|_2^2$$

$$\text{s.t.} \quad \langle V, I\rangle \leq P, \qquad V \succeq 0$$

in which $V = vv^H$ is the lifted variable of vector v. The mentioned optimization can be solved by suggested solution in the previous section.

*MIMO for increasing computation rate*

In subsection, the inventors consider another MIMO extension of the computation model in which the model allows us simultaneously compute functions with different input data for each node. The model would be designed such that it aids us to increasing the rate of computation instead of decreasing the distortion in the previous subsection.

Particularly, we consider the scenario where the goal is to compute $R$ desire functions $f^{(r)}(\mathbf{x}_1, \mathbf{x}_2, \ldots, \mathbf{x}_K): \mathbb{R}^K \mapsto \mathbb{R}$ for $r \in [R]$ whose input $\mathbf{x}_k \in \mathbb{C}^R$ contains $R$ values of $k$-th node i.e. $\vec{\mathbf{x}}_k = [\vec{x}_{k,1}, \vec{x}_{k,2}, \ldots, \vec{x}_{k,R}]^\mathsf{T}$. For the validation, the rate $R$ must be lower than number of transmitters and receivers antenna i.e. $R \leq min\{N_t, N_r\}$. To give better insight, consider the following linear equation

$$f^{(r)} := \sum_k a_{k,r} \, x_{k,r} + b_r,$$

for $r \in [R]$. In the case of $\vec{x}_{k,j} = \vec{x}_{k,i}$ for $i, j \in [R]$ and $k \in [K]$, this model reduce to the previous MIMO model. The measured signals received by CP over MAC at time t is

$$\vec{Y}_n(t) = U^H \left( \sum_{k \in [K]} H_k(t) V_k \vec{x}_k(t) + Z(t) \right),$$

where $V_k \in \mathbb{C}^{N_t \times R}$ and $U \in \mathbb{C}^{N_r \times R}$ are beam-forming matrices at $k$-th transmitter and receiver, respectively. The inventors further define the modulation matrix as

$$\mathbf{X}_k = \left[\vec{\mathbf{x}}_k^1, \dots, \vec{\mathbf{x}}_k^q\right]^\top \in \mathbb{C}^{q \times R},$$

Beside, we define $\quad \mathbf{C}_k := vec\left(\mathbf{V}_k \mathbf{X}_k^\top\right) \in \mathbb{C}^{N_t q \times 1} \quad$ or equivalently $\quad (\mathbf{X}_k \otimes \mathbf{V}_k)\mathbb{I}_{R^2} \quad$ where $\mathbb{I}_{R^2} := vec(\mathbf{I}_{R \times R})$. Accordingly, one has matrix $\tilde{\mathbf{C}} = [\mathbf{C}_1, \dots, \mathbf{C}_K]^\top$ and $\tilde{\mathbf{U}} = \mathbf{I}_{M \times M} \otimes \mathbf{U}$. Therefore, the measured constellation points at CP is

$$\tilde{\mathbf{U}}^H \tilde{\mathcal{A}} \mathcal{B} \mathcal{H} \tilde{\mathbf{C}} = \mathbf{S}$$

where $\mathbf{S} = [\mathbf{s}_1, \dots, \mathbf{s}_M]^\top$ and $\mathbf{s}_k \in \mathbb{C}^R$ for $k \in [M]$. Similarly, it can be seen that matrix $\tilde{\mathbf{C}}$ can be written as $\mathbf{W}\tilde{\mathbf{X}}$ in which $\mathbf{W} = Diag([\mathbf{w}_1, \dots, \mathbf{w}_K])$ and $\mathbf{w}_k := \mathbf{I}_{q \times q} \otimes \mathbf{V}_k$ and $\tilde{\mathbf{X}} = [vec(\mathbf{X}_1), \dots, vec(\mathbf{X}_K)]^\top \in \mathbb{C}^{KRq \times 1}$.

For computing the vector function $\mathbf{f} \in \mathbb{R}^R$, the computation condition in (10) needs to be modified, consequently. The inventors bring this condition in the form of the following proposition.

Proposition 9: Let $f^{(i)} \in \mathbb{R}$ be the i-th output of the function for a certain value of input $x_1, x_2, \dots, x_k$ from $[M \times R]$ possible values of the function $f^{(r)}$s and also, $\mathbf{s}_i \in \mathbb{C}^R$ represents the corresponding R constellation points. Then, the computation is valid if and only if when we have the following

$$if \quad f_i^r \neq f_j^r \ \Rightarrow [\mathbf{s}_i]_r \neq [\mathbf{s}_j]_{r'},$$

for all $r \in [R]$.

The inventors suggest a similar relaxation to (11) for the mentioned condition in Proposition 9 which it would lead to the following feasibility problem

$$\mathcal{P}_{M-feas} = find \qquad \mathbf{V}, \mathbf{U}$$
$$s.t. \qquad \left|[\mathbf{s}_i]_r - [\mathbf{s}_j]_r\right|^2 \geq \varepsilon \left|f_i^{(r)} - f_j^{(r)}\right|^2,$$
$$\forall (i,j) \in [M] \times [M], and, \ r \in [R]$$

For the reliable communication in the case of MIMO, the problem of computing with minimum power can be extended as follows

$$\hat{\mathbf{V}}, \hat{\mathbf{U}} = \qquad \arg\min_{\mathbf{V}, \mathbf{U}} \quad \|\mathbf{V}\|_F^2$$

$$s.t. \quad \left|\mathbf{e}_r^T \mathbf{U}\left(\tilde{A}_i - \tilde{A}_j\right)\mathcal{B}\mathcal{H} \, \mathbf{W}\tilde{X}\right| \geq \gamma_0 \sigma_z^2 \left|f_i^{(r)} - f_j^{(r)}\right|^2,$$

$$\mathbf{U}^H \mathbf{U} = N_r \mathbf{I}_R$$

for $r \in [R]$ and $\mathbf{e}_r \in \mathbb{R}^R$ is the canonical vector whose r-th element is 1 and zero elsewhere. Here, the constraint on $\mathbf{U}$ comes from the orthogonality of function $f^{(r)}$s from each other.

*Minimizing the Maximum Error using MIMO*

Using multiple antennas provide allows computing R different functions at the same time. Before introducing the problem of minimizing the maximum error, the inventors need to redefine the error for this new setup. Hence, let $P_{i,j}^{(r)}$ be probability of the error of computing $f_j^{(r)}$ instead of $f_i^{(r)}$, then, the computation error can be defined as $E_{i,j}^{(r)} := P_{i,j}^{(r)} \left|f_i^{(r)} - f_j^{(r)}\right|$, consequently. Since the decision regions of the function $f^{(r_1)}(x_1, \dots, x_2)$ and function

$f^{(r_2)}(x_1, \dots, x_2)$ are different, there can not be any error $f_i^{(r_1)}$ and $f_i^{(r_2)}$ where $r_1, r_2, \in [R]$ for two different cases of $r_1$ and $r_2$. Finally, the optimization problem reads to

$$\hat{\mathbf{v}}_1, \dots, \hat{\mathbf{v}}_K, \hat{\mathbf{U}} = \underset{\mathbf{v}_1, \dots, \mathbf{v}_K, \mathbf{U}}{argmin} \underset{i,j,r}{\max} \qquad P_{i,j}^{(r)} \left| f_i^{(r)} - f_j^{(r)} \right|$$
$$s.t. \qquad \| \mathbf{v}_k \|_2^2 \le P_k,$$
$$\mathbf{U}^{\mathsf{H}}\mathbf{U} = N_r \mathbf{I}_R,$$

The considered problem can be approximated using similar arguments as prvided in section about noise, and it can finally give

$$\hat{\mathbf{v}}_1, \dots, \hat{\mathbf{v}}_K, \hat{\mathbf{U}} = \underset{\mathbf{v}_1, \dots, \mathbf{v}_K, \mathbf{U}}{argmax} \underset{i,j,r}{\min} \qquad \sum_k \frac{\mathbf{v}_k^{\mathsf{T}} \mathcal{BH}_{i,j}^{(r)} \mathbf{v}_k}{4\sigma_z} - \alpha_{i,j}^{(r)}$$
$$s.t. \qquad \| \mathbf{v}_k \|_2^2 \le P_k,$$
$$\mathbf{U}^{\mathsf{H}}\mathbf{U} = N_r \mathbf{I}_R,$$

where $\alpha_{i,j}^{(r)} = \log\left(\frac{\left| f_i^{(r)} - f_j^{(r)} \right|}{2}\right)$, $P_k$ denotes allocated power budget for node $k$ and $\mathcal{BH}_{i,j}^{(r)} = \beta_{i,j}^{(r)\mathsf{H}}\beta_{i,j}^{(r)}$ in which

$$\beta_{i,j}^{(r)} = \mathbf{e}_r^{\mathsf{T}}\mathbf{U}^{\mathsf{H}}\left(\tilde{\mathbf{A}}_i - \tilde{\mathbf{A}}_j\right)\mathcal{BH}\mathbf{W}\tilde{\mathbf{X}}.$$

*Minimizing the average Error using MIMO*

Based on what has been mentioned in the previous subsection, the inventors need to revise the problem of minimizing the average error coming from detection. More precisely, for probability of the error of computing $f_j^{(r)}$ instead of $f_i^{(r)}$, one can solve the following optimization problem

$$\hat{\mathbf{V}}, \hat{\mathbf{U}} = \underset{\mathbf{V}, \mathbf{U}}{argmin} \qquad \sum_{r=1}^{R} \sum_i^M \pi_{i,r} \sum_{j=1}^M P_{i,j}^{(r)} \left| f_i^{(r)} - f_j^{(r)} \right|^2$$
$$s.t. \qquad \| \mathbf{V} \|_2^2 \le P, \quad \mathbf{U}^{\mathsf{H}}\mathbf{U} = N_r \mathbf{I}_R,$$

where $\pi_{i,r}$ is the probability of transmitting signal to compute $f_i^{(r)}$. Similarly, the cost function can be replaced by Chernoff upper bound which would lead to the following optimization

$$\hat{\mathbf{V}}, \hat{\mathbf{U}} = \underset{\mathbf{V}, \mathbf{U}}{argmin} \sum_{r=1}^{R} \sum_i^M \pi_{i,r} \sum_{j=1}^M \exp\left(-\frac{\langle \mathbf{V}, \mathcal{BH}_{i,j}^{(r)}\rangle}{4\sigma_z}\right)\tilde{\alpha}_{i,j}^{(r)}$$
$$s.t. \quad \langle \mathbf{V}, \mathbf{I}\rangle \le P, \quad \mathbf{V} \succcurlyeq 0, \quad \mathbf{U}^{\mathsf{H}}\mathbf{U} = N_r \mathbf{I}_R,$$

win which $\tilde{\alpha}_{i,j}^{(r)} = \left| f_i^{(r)} - f_j^{(r)} \right|^2$. The mentioned optimization can be solved by suggested solution in the previous section.

*Massive MIMO*

For a large enough number of receiver and transmitter antennas $N_t, N_r \gg 1$, the interference within communication cells can be substantially reduced. With a very large antenna array, the effect of fast fading can be diminished. Accordingly, random characteristics of the channel start to look deterministic. Moreover, when the number of receiver antennas grows large, the stochastic channel vectors between the nodes and the CP become pair-wisely orthogonal.

Here, the inventors consider a massive MIMO scenario for the case of computation and study its effects on the problem setup.

We can model independent fast fading, geometric attenuation, and shadow fading using the channel matrix $G_k$ where the coefficient $g_{n_1,n_2,k}$ can be written as

$$g_{n_1,n_2,k} = h_{n_1,n_2,k}\sqrt{\beta_{n_2,k}}$$

for $n_1 = 1, \ldots, N$, where $h_{n_1,n_2,k}$ is the fast fading coefficient from the $n_2$-th antenna of User $k$ to the $n_1$-th antenna of the CP. $\sqrt{\beta_{n_2,k}}$ denotes the geometric attenuation and shadow fading which is independent over parameter $\ell$. This independency is $\beta_{n_2,k}$ the distances between the users and the CP are always much larger than the distance between the antennas. In addition, the value of $\beta_{n_2,k}$ changes very slowly over time.

Then, we have

$$\mathbf{H}_k = \mathbf{G}_k\sqrt{\mathbf{J}_k}$$

where $\mathbf{G}_k \in \mathbb{C}^{N_r \times N_t}$ denotes the fast fading coefficients between the $k$-th user and the CP. Also, $\mathbf{J}$ is a $N_t \times N_t$ diagonal matrix in which $[\mathbf{J}_k]_{n_2,n_2} = \beta_{n_2,k}$. In the case of massive MIMO, one has

$$\mathbf{H}_k^{\mathsf{H}}\mathbf{H}_k = \sqrt{\mathbf{J}_k}\mathbf{G}_k^{\mathsf{H}}\mathbf{G}_k\sqrt{\mathbf{J}_k} \approx \mathbf{J}_k, \quad N_r \gg N_t$$

Also, for the interference between two different channel $k$ and $k'$, one has

$$\mathbf{H}_{k'}^{\mathsf{H}}\mathbf{H}_k \approx \mathbf{0}$$

Using the resultant features, we obtain the following simplification for the aforementioned MIMO scenarios.

Lemma 2: For the MIMO scenario in (73), if $L$ be equal to $N_r$ and $N_r \gg 1$ the computation condition in (78) can be simplified to

$$\| \mathbf{s}_i - \mathbf{s}_j \|_2^2 = \sum_{k=1}^{K} \| \left(\widetilde{\mathbf{A}}_{k,i} - \widetilde{\mathbf{A}}_{k,i}\right)\mathcal{B}\mathcal{H}_k\mathcal{X}_k\mathbf{v}_k \|_2^2,$$

for $i,j \in [M^L] \times [M^L]$, where $\mathcal{B}\mathcal{H}_k := diag(\mathbf{I}_{q \times q} \otimes \mathbf{H}_k)$ and $X_k := diag(\mathbf{x}_k \otimes \mathbf{I}_{N_t \times N_t})$ where $\widetilde{\mathbf{A}}_{k,i} \in \mathbb{C}^{MN_r \times N_r q}$ denotes $i$-th rows of $k$-th column block of matrix $\widetilde{\mathbf{A}}$. Here, we supposed $\mathbf{U}\mathbf{U}^{\mathsf{H}} = N_r \mathbf{I}_{N_r}$ which is acceptable considering the fact that $L = N_r$.

One can simplified the optimization problem in (50), and it can be reformulated as follows

$$\widehat{v_1}, \ldots, \widehat{v_k} = \arg \min_{v_1,\ldots,v_k \sum_{k=1}^{K}} \left|\left|v_k\right|\right|_2^2$$

$$\text{s.t.} \sum_{k=1}^{K} \left|\left|(\widetilde{A_{k,i}} - \widetilde{A_{k,j}})\mathcal{B}\mathcal{H}_k\mathcal{X}_k v_k\right|\right|_2^2 \geq \gamma_0 \sigma_z^2 \left|\left|\mathsf{f}_i - \mathsf{f}_j\right|\right|_2^2$$

The other optimization problem can be derived in similar manner.

*Broadband Digital Over-the-Air Computation via OFDM*

The inventors use OFDM symbols for the case where the CP has access to the - frequency wireless channel on the same time resources. Indeed, each node is able to send its signal over a subset of the frequencies under a certain power constraint. The CP receives aggregated values at the parallel channels and then computes the sum of the values of nodes for each channel, separately. The OFDM modulation is tailored to divide the available bandwidth into orthogonal sub-channels. This requires mapping each quantized data element to one digital symbol to facilitate the ChannelComp method. Particularly, the transmitted baseband OFDM symbol of the $k$-th nodes in the time slot, can be expressed as

$$t_k = \mathcal{F}_{NI}^{\cdot}(L\mathcal{F}\{x_k(t)\}),$$

where $\mathcal{F}_{NI}^{\cdot}$ denotes the $NI$ point inverse Fourier transform and $\mathcal{F}_F$ is the $F$-point Fourier transform. Also, $L \in \mathbb{R}^{NI \times F}$ is the mapping matrix that maps the output of the Fourier transform pre-coder to a set of contiguous sub-carriers, and $x_k(t) \in \mathbb{C}^f$ contains the $f$ symbols.

The investors consider the cyclic prefix duration to be larger than the synchronization offset, in which the offset equals a phase shift of the received symbol. Then, the superposed symbol on the $f$ sub-carrier OFDM symbols at the CP at time slot can be written as

$$\overrightarrow{y_f}(t) = \sum_{k=1}^{K} h_{k,f}(t)\overrightarrow{t_{k,f}}(t) + \overrightarrow{z_f}(t)$$

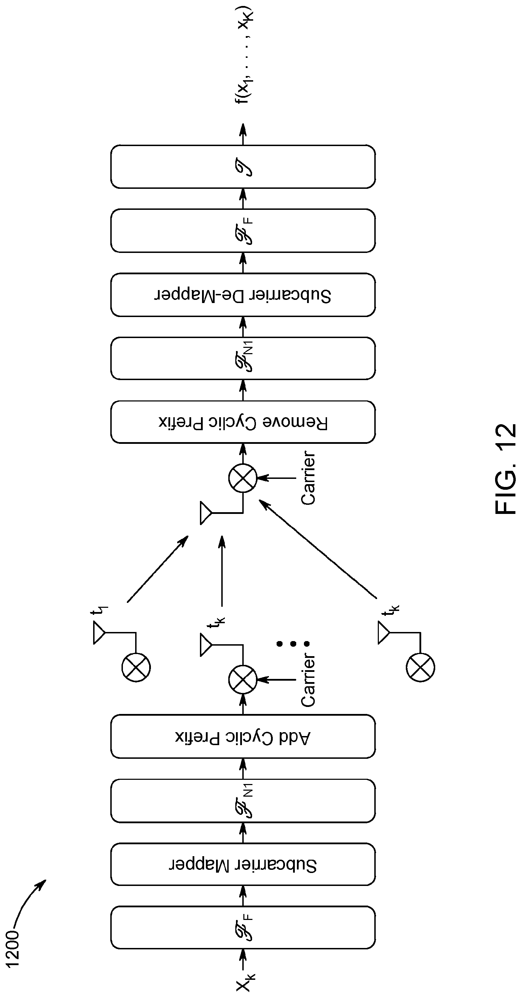

where $h_{k,f}$ is the channel coefficient between the CP and $k$-th node, $\overrightarrow{t_{k,f}}$ is the transmitted symbol from the $f$-th node, $\overrightarrow{z_f}$ is the symmetric AWGN with zero mean and the variance $\sigma_z^2$ on the f-th sub-carrier. The transmitter and the receiver design for edge devices are shown in Figure 12.

*Asynchronous computation over the air*

One of the well-known challenges in the over-the-air problem is to have a strict time synchronization over all the devices. To overcome this issue, one can use the *timing advance* technique. In particular, one needs to consider the propagation delay of each device regardless of their location, and then change the tabular function $\mathcal{T}$ based on the constellation diagram of the corresponding transmitted devices in regard of the time.

More specifically, let $\overrightarrow{x_k}(t)$ represents the modulation vector of $k$-th user in the time slot $t \in [T]$ where denotes the set of time slots of interest. For sake of simplicity, suppose that the desired function $f$ can be written as $f(x) = \sum_{k=1}^{K} g_k(x_k)$ where $g_k(.): \mathbb{R} \mapsto \mathbb{R}$. Also, consider for user $k$ in which $k \in \{1,2, \dots, L\}$, we have same delay, and the rest of the users are in different locations and have different propagation delays i.e. $k' \in \{L + 1, L + 2, ..., T\}$. Hence, the desire function can be divided into two functions $f_1$ and $f_2$ as follows

$$f(x) = \sum_{k=1}^{L} g_k(x_k) + \sum_{k'=L+1}^{K} g_{k'}(x_{k'}) = f_1(x) + f_2(x)$$

Therefore, the inventors have realized that one may compute the function $f$ using two tabular functions $\mathcal{T}_1$ and $\mathcal{T}_2$ in two time slots $t_1$ and $t_2$ corresponding to the functions $f_1$ and $f_2$, respectively. Consequently, one way that the inventors have realizzed to handle noise and find proper modulation is to solve an optimization problem for each function separately. Although, the discussed cases consist of two delays, extending to the higher number of delays is straightforward.

For the case of inseparable functions as long as can be the sequence of the functions can be uniquely determined, or there is a set of unique sequences generated by the same input, the desired function can be computed. In fact, in the aforementioned example, to compute functions $f_1$ and $f_2$, it is required to have knowledge of the input domain of functions. However, one can consider cases in which function and have the same domain and computing the other one required information of the other one's input. In this regard, the inventors have realized that one may decode the domain of the functions as well.

Consider we first compute the function $f_1$ and $f_2$ with domain $\mathcal{D}_1 = \{x_1, x_2, \dots, x_L\}$ and $\mathcal{D}_2 = \{x_{L+1}, x_{L+2}, \dots, x_K\} \cup \{x_1\}$ at time $t_1$ and $t_2$, respectively where $t_1 < t_2$. Then, for computing function $f_2$, it needs to know the value of the first user $x_1$ which is transmitted in time $t_1$. Therefore, the constraint in feasibility check optimization would be changed and investors suggest the following optimization

$$\mathcal{P}_1^{asynch} = \text{find} \quad x$$
$$\text{s.t.} \quad \text{if } f_{1i} \neq f_{1j} \text{ or } x_1^i \neq x_1^j \Rightarrow s_i \neq s_j$$
$$\forall (i,j) \in [M] \times [M]$$

where $x_1^i$ denotes the corresponding values of $x_1$ to the output of $f_{1i}$. Consequently, the inventors have realized that one can relax these conditions as follows

$$\mathcal{P}_2^{asynch} = \text{find} \quad x$$
$$\text{s.t.} \quad \text{if } |s_i - s_j|^2 \geq |f_{1i} - f_{1j}|^2 + |x_1^i - x_1^j|^2$$
$$\forall (i,j) \in [M] \times [M]$$

Finally, the inventors have realized that one can compute function $f$ from the computed values of $f_1$ and $f_2$ from the previous steps.

*Example of ChannelComp decoder*

The decoder can be determined as long as the solution to Problem $\mathcal{P}_2$ satisfies its constraints. In one embodiment the maximum likelihood estimator (MLE) is used and the decision boundaries are designed based on the reshaped constellation points over the MAC.

Next, the tabular function $\mathcal{T}(\cdot)$ maps the received signal $\vec{y}(t)$ to the desired output of the function $f$ Specifically, we define $\vec{g}_i := \sum_{k=1}^{K} \vec{x}_k$ as the constellation point for the function $f^{(i)}$. Then, the problem is to find which $\vec{g}_i$'s values were transmitted while we have received $\vec{y}$. Hence, the MLE estimator gives us the following:

$$\hat{f}^{(i)} = \arg\max_i Pr(\vec{y}|\vec{g}_i),$$

where $= \frac{1}{\sqrt{2\pi\sigma_Z^2}} exp\left[\frac{-\|\vec{y}-\vec{g}_i\|_2^2}{2\sigma_Z^2}\right]$ follows a Normal distribution. Next, taking logarithm results in (99):

$$\hat{f}^{(i)} = \arg\max_i \|\vec{y} - \vec{g}_i\|_2^2,$$

Using the expression in (99), the decoder generates the set of all possible constellation points $\{\vec{g}_1, ..., \vec{g}_M\}$ with the corresponding Voronoi cells $\{V_1, ..., V_M\}$. Then, the desired value is given by

$$\hat{f} = \sum_{j=1}^{M} \mathcal{T}_j(\vec{y}),$$

In which the look-up table is

$$\mathcal{T}_j(\vec{g}) := \begin{cases} f^{(j)} & \vec{g} \in \mathcal{V}_j \\ 0 & \text{othewise.} \end{cases}$$

For those cases where the computation conditions in $\mathcal{P}_2$ are not established, we have the same constellation point $\vec{g}_i$ at different values of the function, e.g., $f^{(i)}$ and $f^{(i+1)}$. Hence, these points have the same Voronoi cell, i.e., $V_i = V_{i+1}$, and the output values can be replaced by their mean, i.e.,

$$\mathcal{T}_i(\vec{g}) = \mathcal{T}_{i+1}(\vec{g}) := \begin{cases} \dfrac{f^{(i)} + f^{(i+1)}}{2} & \vec{g} \in \mathcal{V}_i, \mathcal{V}_{i+1} \\ 0 & \text{othewise.} \end{cases}$$

With this decoder, we are able to compute the desired function based on received signal $\vec{y}(t)$ over the MAC.

*Generalizing to linear systems*

Time-variant communication channels are commonly represented as linear systems that react to a transmitted signal through a weighted combination of its delayed and Doppler-shifted versions. Therefore, a communication channel can be identified by an impulse response of the system $H(t, \tau)$ where $t$ and $\tau$ denotes delayed and Doppler. For the case of usual linear time-invariant channel, the impulse response is given by

$$H(\tau) = \sum_i a_i \delta(\tau - \tau_i),$$

Where $\delta(\cdot)$ is the delta function and $a_i$ denotes the attention of the path $i$ of channel. By taking this generalization into the problem, consider a communication network involves $K$ nodes and the CP server. To compute the desired function $f(x_1, \dots, x_K)$, $k$-*th* node transmits signal $\overline{x}_k(t)$ over the linear system. Thus, the CP receives the following signal at time $t$,

$$y(t) = \sum_{k=1}^{K} H_k(t, \tau) \circledast x(t) + z(t)$$

$$= \sum_{k=1}^{K} \int H_k(t, \tau) x_k(t - \tau) d\tau + +z(t)$$

where $H_k(t, \tau)$ is the impulse response of the communication channel between node $k$ and the CP. Towards computing the function $f$, we set $x_k(t) := x_k r(t)$ where $x_k$ is the scalar input value for the function $f$, and $r(t)$ is the waveform for transmitting the input value. Afterward, the received signal $y(t)$ goes through the matched filter $r^*(-t)$, and the output is given by

$$y^o(t) = y(t) \circledast r^*(-t) = \sum_{k=1}^{K} \int \int H_k(t', \tau) x_k r(t' - \tau) r(t + t') d\tau dt' + \check{z}(t).$$

Next, the output is sampled at time $T$, which determines the time duration of the waveform $r(t)$. The resultant sample can be considered as a constellation point $s = y^o(T)$ Because $x_k$ are constructed from finite constellation points, accordingly, $y^o(t)$ in the absence of AWGN, we would have a reshaped constellation of a finite number of points. Therefore, following a similar step as in fading model in this disclosure result in an optimization problem whose solution satisfies the computation conditions. By satisfying the computation constraint, using an appropriate look-up table, computing the desired function $f$ over any linear system can be done.

*Applications*

AirComp has a massive potential for lowering communication costs in applications such as distributed ML, specifically federated learning. The inventors explain federated edge learning (FEEL) framework here and discuss how the presently disclosed methods can be employed for the purpose of communication-efficient in FEEL framework.

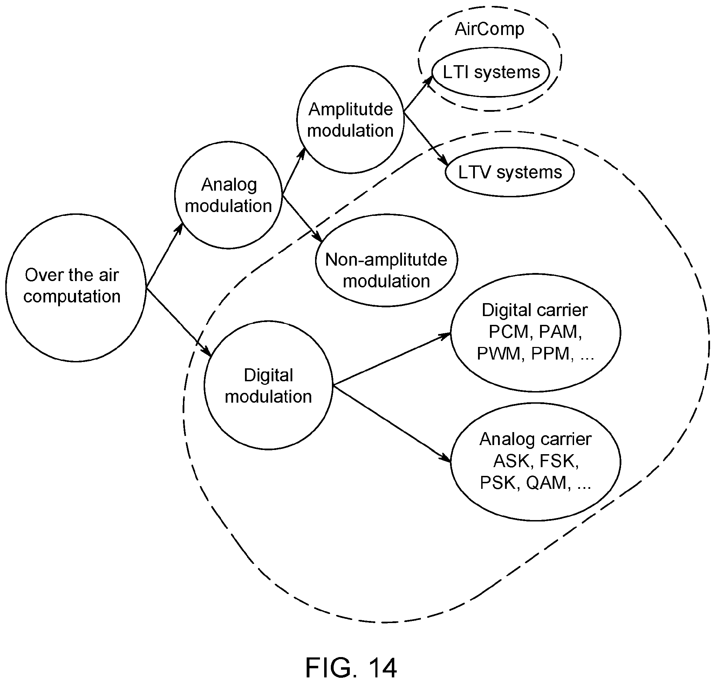

Fig. 14 shows an overview of application of the presently disclosed computer-implemented method for in-channel function computation. Preferably, the input data is encoded according to a digital modulation scheme. One embodiment comprises analog modulation but non-amplitude modulation. A further embodiment comprises analog modulation, non-amplitude modulation, but channel computation in a linear time variant (LTV) system.

*Federated Edge Learning*

Following the existing literature the loss function measuring the model error is defined as follows. Let $\mathcal{D}_k$ denotes the local dataset collected at the $k$-th edge device. Then, the global loss function of the model vector w on $\mathcal{D}_k$ is given by

$$F(\mathbf{w}) = \frac{\sum_k |\mathcal{D}_k| F_k(\mathbf{w})}{|\mathcal{D}|}$$

where $\mathcal{D} = \Sigma_k |\mathcal{D}_k|$ and function $F_k(\mathbf{w})$ represents the average empirical loss at device $k$ with respect to model parameters w , i.e.

$$F_k(\mathbf{w}) = \frac{1}{|\mathcal{D}_k|} \sum_{j \in \mathcal{D}_k} f_j(\mathbf{w})$$

where $f_j(\mathbf{w})$ is the empirical loss function at j-th data sample in local data sample. The goal of learning is to train the global model using local data-set of each user by minimizing the following empirical cost function through a distributed manner

$$\mathbf{w}^* = \underset{\mathbf{w}}{arg\,min}\; F(\mathbf{w})$$

To preserve privacy, one can employ the FEEL framework in which each devices using local data $\mathcal{D}_k$ performs stochastic gradient descent (SGD) to minimize the local loss function $f_j(\mathbf{w})$. More precisely, let $\mathbf{g}_k^{(t)}$ be the local estimated gradient of device $k$ at $t$-th communication round between devices and server which is given by

$$\mathbf{g}_k^{(t)} = \frac{1}{|\mathcal{D}_k|} \sum_{j \in \mathcal{D}_k} \nabla f_j(\mathbf{w}^{(t)})$$

where $\mathbf{w}^{(t)}$ represents parameter and $\nabla$ denotes the gradient operator. The $\nabla f_j(\mathbf{w}^{(t)})$ can be computed by performing SGD using local data sample $\mathcal{D}_k$. Afterwards, k-th device aims to send its local model update $\mathbf{g}_k^{(t)}$ to the server CP for $k \in [K]$. Then, the global model of the gradient $\mathbf{g}^{(t)}$ of the loss function F(w) would be computed by

$$\mathbf{g}^{(t)} = \frac{1}{K} \sum_{k=1}^{K} \mathbf{g}_k^{(t)}$$

Finally, the server updates the current model using gradient descent using following equation

$$\mathbf{w}^{(t+1)} = \mathbf{w}^{(t)} - \eta \mathbf{g}^{(t)}$$

where $\eta$ is the learning rate. The inventors only require the aggregation of the local estimations $\mathbf{g}_k^{(t)}$ not the individual gradient. Therefore, the inventors can employ the described communication efficient ChannelComp method, presently disclosed, to compute the aggregation function over the air whose details will be explained in the sequel subsection.

*Communication model*

To setup the communicating model, the inventors first need to define the modulation such that the desired function can be computed uniquely using tabular function. During the up-link phase (transmitting gradients to CP), all the devices simultaneously send their data based on available bandwidth. The communication can be done using broad band setup and device $k$ sends a vector of size F, $\tilde{\mathbf{g}}_k^{(t)}$ which consist of F elements of estimated gradient of device $k$ i.e. $\mathbf{g}_k^{(t)}$ at communication round $t$. In what follows, we explain how to design the modulation of each sub-carrier. The desirable function here is a simple aggregation which a symmetry function. For the symmetric function from Proposition 1, we know that using same modulation for all devices is enough to preform computation. Hence, we assume that a fixed digital constellation $\vec{x} = [x_1, ..., x_q]^H$, where q is the size of quantization, is employed by all the devices to transmit data over fading channel with known CSI. With out loss of generality, assume that the quantized value of all gradients are integer and in [0, $q$ - 1]. Consequently, the desired function would be

$$f(x_1, \dots, x_K) = \sum_{k=1}^{K} x_k \,,$$

where for the range of function $f$ we have that $R_f = [0, K(q-1)]$. By sorting the output of function in non-decreasing order, let $f_j$ corresponds to j-th value of the function for $j \in [0, q^K]$, e.g. $f_1 = f(0, \dots, 0) = 0$ and $f_M = f(q-1, \dots, q-1) = K(q-1)$ where $M = q^K$. Then, the inventors recall the optimization problem regrading valid computation as below (107)

$$\hat{\mathbf{x}} = \underset{\mathbf{x}}{arg min} \qquad \| \mathbf{x} \|_2^2$$

$$s.t. \qquad \left| (\mathbf{a}_i - \mathbf{a}_j)^\top \mathcal{H}(\mathbf{h})\mathbf{x} \right|^2 \geq \gamma_0 \sigma_z^2 \left| f_i - f_j \right|^2,$$

where $(i,j) \in [M] \times [M]$. For solving optimization problem in (107), one can follow the procedure in ad-hoc Algorithm and obtain the optimum modulation choice for the communication. The other suggested optimization problem suggested in Section about noise also can be used in similar manner to select the optimum modulation.

The inventors further consider the scenario in which the modulation are given and we are not able to change the modulation e.g. standard modulation QAM, BPSK. Instead, we can use pre-coders to change the phase or the allocated power of data for each user. Particularly, let $b_k$ be the pre-coder at device $k$. Then, we have the following measurements in time slot $t$ at CP,

$$\vec{y}_n = \sum_{k \in [K]} h_k b_k \vec{x}_k + z,$$

Here, $h_k$ is the coefficient channel between CP and k-th node. Also, the inventors assume modulation vector are normalized i.e. $|\vec{x}_k|^2 = 1$ for $k \in [K]$ and the allocated power is controlled by $b_k$ such that $|b_k| = \sqrt{p_k}$. Now, if we rewrite problem (107) in this setup, it reads to

$$\hat{\mathbf{b}} = \underset{\mathbf{b}}{arg min} \qquad \| \mathbf{b} \|_2^2$$

$$s.t. \quad \left| (\mathbf{a}_i - \mathbf{a}_j)^\top \mathcal{H}(\mathbf{h}) diag(\mathbf{x})\mathbf{b} \right|^2 \geq \gamma_0 \sigma_z^2 \left| f_i - f_j \right|^2,$$

where $\mathbf{b} = [b_1, \dots, b_K]^H$.

*Proof of Proposition 2*

In the case where all users use same modulation $\varepsilon_k = \varepsilon$ for $k \in [K]$, the summation over the air can be considered as symmetry function $\mathcal{G}(.) = \Sigma_{k \in [K]} \varepsilon (.)$. Consequently, to compute the upper bound, the outputs of function need to be as much as possible distinguishable which it means that all the outputs of $\varepsilon(.)$ are distinct. Therefore, the range of $\varepsilon(x)$ would be q for $x \in [0, 1, \dots, q]$. Next, we need to count the number of possible distinct output for the function $\mathcal{G}(x_1, \dots, x_K) = \Sigma_{k \in [K]} \varepsilon (x_k)$. Each $x_k$ has q discount the number of ways that we can select one level of $x_k$ such that output of function $\mathcal{G}$ be different. This is exactly the combinatorial problem balls and bins where we seek to find number of possible ways to put $n$ indistinguishable balls into $k$ distinguishable bins. Here, bins are possible values of variables $x_k$s and balls are modulation map $\varepsilon$. Therefore, using the formula of balls and bins, we get the upper bound $\binom{K+q-1}{q-1}$.

For the lower bound, the inventors consider scenario where the outputs of each $\varepsilon(x_k)$ have overlap with each other. The most overlap occurs when $\varepsilon$ be a linear function. As a result, for the function $\mathcal{G}$ we have that

$$\mathcal{G}(x_1, \dots, x_K) = \sum_{k \in [K]} \varepsilon (x_k) = \varepsilon \left( \sum_{k \in [K]} x_k \right)$$

Now, to count the number of possible value of outputs of function $\mathcal{G}$ equals to the range of function $\varepsilon$ which is the number of possible values of range of $\sum_{k \in [K]} x_k$, since $\varepsilon$ is a linear function. It is not difficult to see that the range of $\sum_{k \in [K]} x_k$ for $x_k \in \{0, 1, ..., q - 1\}$ is $K(q - 1) + 1$.

## Claims

1. A computer-implemented method (100) for in-channel function computation in a digital communication system (500) comprising a plurality of transmitting digital units (501) and one or more channels (502), the method comprising the steps of:

   - digitally encoding input data according to one or more transmitting encoding schemes (201, 202), wherein the input data is encoded according to a digital modulation scheme, wherein the digital modulation scheme is an amplitude-based and phased-based modulation scheme (101);
   - transmitting digitally encoded input data having changed phase and amplitude from the plurality of transmitting digital units (501) through the one or more channels (502) (102);
   - obtaining superpositions of the digitally encoded input data from the plurality of the transmitting digital units (501) in the one or more channel (502) (103);
   - based on a decoding scheme, which assigns, to any one of the possible superpositions of the transmitted digitally encoded input data, a predefined value corresponding to a predefined combination of the digitally encoded input data, decoding the superpositions of transmitted digitally encoded input data, thereby obtaining combinations of the digitally encoded input data, wherein the step of decoding the superpositions of transmitted digitally encoded input data comprises determining the phase and amplitude of the transmitted signals comprising superpositions of the digitally encoded input data, and mapping the signals to predefined combinations or functions of the input data (104).

2. The method (100) for in-channel function computation according to claim 1, wherein the input data comprises several input data sources comprising at least first input data, transmitted using a first transmitting digital unit (501), and second input data, transmitted using a second transmitting digital unit (501).

3. The method (100) for in-channel function computation according to any one of the preceding claims, wherein the channels (502) are time-invariant or time-variant channels.

4. The method (100) for in-channel function computation according to any one of the preceding claims, wherein computation and transmission occurs simultaneously.

5. The method (100) for in-channel function computation according to any one of the preceding claims, wherein the superpositions of the digitally encoded input data are obtained by interference of transmitting signals from the plurality of transmitting digital units (501) carrying the transmitted digitally encoded input data.

6. The method (100) for in-channel function computation according to any one of the preceding claims, wherein the decoding scheme comprises a number of constellation points (206) equal to or more than a number of possible combinations of input data and/or wherein the superpositions of the transmitted digitally encoded input data have a number of superposed constellation points (206) greater than constellation points of digital modulation scheme used for encoding the input data.

7. The method (100) for in-channel function computation according to any one of the preceding claims, wherein the transmitting encoding scheme (201, 202) and the decoding scheme associate each superposition of the digitally encoded input data with a predefined unique combination of input data, preferably comprising input data from at least first input data, transmitted using a first transmitting digital unit (501), and second input data, transmitted using a second transmitting digital unit (501).

8. The method (100) for in-channel function computation according to claim 7, wherein the step of decoding the superpositions of transmitted digitally encoded input data comprises extracting the unique combinations for the received superpositions of transmitted digitally encoded input data.

9. The method (100) for in-channel function computation according to any one of the preceding claims, wherein the transmitted digitally encoded input data is transmitted over signals with different transmission power.

10. The method (100) for in-channel function computation according to any one of the preceding claims, wherein the transmitted digitally encoded input data from the transmitting digital units (501) are transmitted at a same carrier frequency and/or wherein the transmitted digitally encoded input data from the transmitting digital units (501) are transmitted at a same time.

11. The method (100) for in-channel function computation according to any one of the preceding claims, wherein the decoding scheme is implemented in a look-up-table, LUT.

12. The method (100) for in-channel function computation according to any one of the preceding claims, wherein the step of decoding the superpositions of transmitted digitally encoded input data further comprises error correction, and/or synchronization, and/or acquisition of channel state information.

13. The method (100) for in-channel function computation according to any one of the preceding claims, wherein input data are gradients and/or parameters of a machine learning model and/or wherein the combination of input data is a federated average of machine learning models.

14. The method (100) for in-channel function computation according to any one of the preceding claims, wherein the digitally encoded input data from the plurality of transmitting digital units (501) is transmitted asynchronously and is decoded based on a unique time sequence of superpositions.

15. A digital communication system (500) comprising a plurality of transmitting digital units (501); one or more channels (502); and at least one digital receiver (503), the transmitting digital units (501) utilizing one or more transmitting encoding schemes (201, 202) for encoding input data and transmit digitally encoded input data, wherein the input data is encoded according to a digital modulation scheme, wherein the digital modulation scheme is an amplitude-based and phased-based modulation scheme, the one or more channels (502) configured to obtain superpositions of transmitted digitally encoded input data, wherein the receiver is configured to decode said superpositions as combinations of transmitted digitally encoded input data, based on a decoding scheme which assigns to any of the possible superpositions a predefined value corresponding to a predefined combination of the digitally encoded input data, wherein the receiver is configured to decode the superpositions by determining the phase and amplitude of the transmitted digitally encoded input data, and mapping the signals to predefined combinations or functions of the input data.

## Patentansprüche

1. Computerimplementiertes Verfahren (100) zur kanalinternen Funktionsberechnung in einem digitalen Kommunikationssystem (500), umfassend eine Mehrzahl von sendenden digitalen Einheiten (501) und einen oder mehrere Kanäle (502), wobei das Verfahren die folgenden Schritte umfasst:

• digitales Codieren von Eingabedaten gemäß einem oder mehreren sendenden Codierungsschemata (201, 202), wobei die Eingabedaten gemäß einem digitalen Modulationsschema codiert werden, wobei das digitale Modulationsschema ein amplitudenbasiertes und phasenbasiertes Modulationsschema ist (101);
• Übertragen digital codierter Eingabedaten mit geänderter Phase und Amplitude von der Mehrzahl der sendenden digitalen Einheiten (501) durch den einen oder die mehreren Kanäle (502) (102);
• Erhalten von Überlagerungen der digital codierten Eingabedaten von der Mehrzahl der sendenden digitalen Einheiten (501) in dem einen oder den mehreren Kanälen (502) (103);
• auf der Grundlage eines Decodierungsschemas, das einer beliebigen der möglichen Überlagerungen der übertragenen digital codierten Eingabedaten einen vordefinierten Wert entsprechend einer vordefinierten Kombination der digital codierten Eingabedaten zuweist, Decodieren der Überlagerungen der übertragenen digital codierten Eingabedaten, wodurch Kombinationen der digital codierten Eingabedaten erhalten werden, wobei der Schritt des Decodierens der Überlagerungen der übertragenen digital codierten Eingabedaten das Bestimmen der Phase und der Amplitude der übertragenen Signale umfasst, umfassend die Überlagerungen der digital codierten Eingabedaten, sowie das Zuordnen der Signale zu vordefinierten Kombinationen oder Funktionen der Eingabedaten (104).

2. Verfahren (100) zur kanalinternen Funktionsberechnung nach Anspruch 1, wobei die Eingabedaten mehrere Eingabedatenquellen umfassen, die zumindest erste Eingabedaten umfassen, die unter Verwendung einer ersten sendenden digitalen Einheit (501) übertragen werden, und zweite Eingabedaten, die unter Verwendung einer zweiten sendenden digitalen Einheit (501) übertragen werden.

3. Verfahren (100) zur kanalinternen Funktionsberechnung nach einem der vorangehenden Ansprüche, wobei die Kanäle (502) zeitinvariante oder zeitvariante Kanäle sind.

4. Verfahren (100) zur kanalinternen Funktionsberechnung nach einem der vorangehenden Ansprüche, wobei Berechnung und Übertragung gleichzeitig erfolgen.

5. Verfahren (100) zur kanalinternen Funktionsberechnung nach einem der vorangehenden Ansprüche, wobei die Überlagerungen der digital codierten Eingabedaten durch Interferenz von sendenden Signalen von der Mehrzahl der sendenden digitalen Einheiten (501) erhalten werden, die die übertragenen digital codierten Eingabedaten tragen.

6. Verfahren (100) zur kanalinternen Funktionsberechnung nach einem der vorangehenden Ansprüche, wobei das Decodierungsschema eine Anzahl von Konstellationspunkten (206) umfasst, die gleich oder größer ist als eine Anzahl möglicher Kombinationen von Eingabedaten und/oder wobei die Überlagerungen der übertragenen digital codierten Eingabedaten eine Anzahl überlagerter Konstellationspunkte (206) aufweisen, die größer ist als die Konstellationspunkte des digitalen Modulationsschemas, das zum Codieren der Eingabedaten verwendet wird.

7. Verfahren (100) zur kanalinternen Funktionsberechnung nach einem der vorangehenden Ansprüche, wobei das sendende Codierungsschema (201, 202) und das Decodierungsschema jede Überlagerung der digital codierten Eingabedaten mit einer vordefinierten eindeutigen Kombination von Eingabedaten verknüpfen, vorzugsweise umfassend Eingabedaten von zumindest ersten Eingabedaten, die unter Verwendung einer ersten sendenden digitalen Einheit (501) übertragen werden, und zweiten Eingabedaten, die unter Verwendung einer zweiten sendenden digitalen Einheit (501) übertragen werden.

8. Verfahren (100) zur kanalinternen Funktionsberechnung nach Anspruch 7, wobei der Schritt des Decodierens der Überlagerungen der übertragenen digital codierten Eingabedaten das Extrahieren der eindeutigen Kombinationen für die empfangenen Überlagerungen der übertragenen digital codierten Eingabedaten umfasst.

9. Verfahren (100) zur kanalinternen Funktionsberechnung nach einem der vorangehenden Ansprüche, wobei die übertragenen digital codierten Eingabedaten über Signale mit unterschiedlicher Sendeleistung übertragen werden.

10. Verfahren (100) zur kanalinternen Funktionsberechnung nach einem der vorangehenden Ansprüche, wobei die übertragenen digital codierten Eingabedaten von den sendenden digitalen Einheiten (501) bei derselben Trägerfrequenz übertragen werden und/oder wobei die übertragenen digital codierten Eingabedaten von den sendenden digitalen Einheiten (501) zur gleichen Zeit übertragen werden.

11. Verfahren (100) zur kanalinternen Funktionsberechnung nach einem der vorangehenden Ansprüche, wobei das Decodierungsschema in einer Nachschlagetabelle, LUT, implementiert ist.

12. Verfahren (100) zur kanalinternen Funktionsberechnung nach einem der vorangehenden Ansprüche, wobei der Schritt des Decodierens der Überlagerungen der übertragenen digital codierten Eingabedaten ferner Fehlerkorrektur und/oder Synchronisation und/oder Erfassung von Kanalzustandsinformationen umfasst.

13. Verfahren (100) zur kanalinternen Funktionsberechnung nach einem der vorangehenden Ansprüche, wobei Eingabedaten Gradienten und/oder Parameter eines maschinellen Lernmodells sind und/oder wobei die Kombination der Eingabedaten ein föderierter Durchschnitt von maschinellen Lernmodellen ist.

14. Verfahren (100) zur kanalinternen Funktionsberechnung nach einem der vorangehenden Ansprüche, wobei die digital codierten Eingabedaten von der Mehrzahl der sendenden digitalen Einheiten (501) asynchron übertragen werden und auf der Grundlage einer eindeutigen zeitlichen Abfolge von Überlagerungen decodiert werden.

15. Digitales Kommunikationssystem (500), umfassend eine Mehrzahl von sendenden digitalen Einheiten (501); einen oder mehrere Kanäle (502); und zumindest einen digitalen Empfänger (503), wobei die sendenden digitalen Einheiten (501) ein oder mehrere sendende Codierungsschemata (201, 202) zum Codieren von Eingabedaten verwenden und digital codierte Eingabedaten übertragen, wobei die Eingabedaten gemäß einem digitalen Modulationsschema codiert werden, wobei das digitale Modulationsschema ein amplitudenbasiertes und phasenbasiertes Modulationsschema ist, wobei der eine oder die mehreren Kanäle (502) dazu konfiguriert sind, Überlagerungen von übertragenen digital codierten Eingabedaten zu erhalten, wobei der Empfänger dazu konfiguriert ist, diese Überlagerungen als Kombinationen von übertragenen digital codierten Eingabedaten auf der Grundlage eines Decodierungsschemas zu decodieren, das jeder der möglichen Überlagerungen einen vordefinierten Wert entsprechend einer vordefinierten Kombination der digital codierten Eingabedaten zuweist, wobei der Empfänger dazu konfiguriert ist, die Überlagerungen durch Bestimmen der Phase und der Amplitude der übertragenen digital codierten Eingabedaten zu decodieren und die Signale vordefinierten Kombinationen oder Funktionen der Eingabedaten zuzuordnen.

**Revendications**

1. Procédé mis en œuvre par ordinateur (100) pour un calcul de fonction dans le canal dans un système de communication numérique (500) comprenant une pluralité d'unités numériques émettrices (501) et un ou plusieurs canaux (502), le procédé comprenant les étapes consistant à :

   • coder numériquement des données d'entrée selon un ou plusieurs schémas de codage d'émission (201, 202), dans lequel les données d'entrée sont codées selon un schéma de modulation numérique, dans lequel le schéma de modulation numérique est un schéma de modulation basé sur l'amplitude et la phase (101) ;
   • transmettre des données d'entrée codées numériquement présentant une phase et une amplitude modifiées depuis la pluralité d'unités numériques émettrices (501) à travers le ou les canaux (502) (102) ;
   • obtenir des superpositions des données d'entrée codées numériquement provenant de la pluralité d'unités numériques émettrices (501) dans le ou les canaux (502) (103) ;
   • sur la base d'un schéma de décodage, qui attribue, à chacune des superpositions possibles des données d'entrée transmises et codées numériquement, une valeur prédéfinie correspondant à une combinaison prédéfinie des données d'entrée codées numériquement, décoder les superpositions des données d'entrée transmises et codées numériquement, permettant ainsi d'obtenir des combinaisons des données d'entrée codées numériquement, dans lequel l'étape de décodage des superpositions des données d'entrée transmises et codées numériquement comprend la détermination de la phase et de l'amplitude des signaux transmis comprenant des superpositions des données d'entrée codées numériquement, et la mise en correspondance des signaux avec des combinaisons ou des fonctions prédéfinies des données d'entrée (104).

2. Procédé (100) de calcul de fonction dans le canal selon la revendication 1, dans lequel les données d'entrée comprennent plusieurs sources de données d'entrée comprenant au moins des premières données d'entrée, transmises à l'aide d'une première unité numérique émettrice (501), et des secondes données d'entrée, transmises à l'aide d'une seconde unité numérique émettrice (501).

3. Procédé (100) de calcul de fonction dans le canal selon l'une quelconque des revendications précédentes, dans lequel les canaux (502) sont des canaux invariants dans le temps ou variants dans le temps.

4. Procédé (100) de calcul de fonction dans le canal selon l'une quelconque des revendications précédentes, dans lequel le calcul et la transmission ont lieu simultanément.

5. Procédé (100) de calcul de fonction dans le canal selon l'une quelconque des revendications précédentes, dans lequel les superpositions des données d'entrée codées numériquement sont obtenues par interférence de signaux émis depuis la pluralité d'unités numériques émettrices (501) transportant les données d'entrée transmises et codées numériquement.

6. Procédé (100) de calcul de fonction dans le canal selon l'une quelconque des revendications précédentes, dans lequel le schéma de décodage comprend un nombre de points de constellation (206) égal ou supérieur à un nombre de combinaisons possibles de données d'entrée et/ou dans lequel les superpositions des données d'entrée transmises et codées numériquement présentent un nombre de points de constellation superposés (206) supérieur au nombre de points de constellation du schéma de modulation numérique utilisé pour coder les données d'entrée.

7. Procédé (100) de calcul de fonction dans le canal selon l'une quelconque des revendications précédentes, dans lequel le schéma de codage d'émission (201, 202) et le schéma de décodage associent chaque superposition des données d'entrée codées numériquement à une combinaison unique prédéfinie de données d'entrée, comprenant de préférence des données d'entrée provenant au moins de premières données d'entrée, transmises à l'aide d'une première unité numérique émettrice (501), et de secondes données d'entrée, transmises à l'aide d'une seconde unité numérique émettrice (501).

8. Procédé (100) de calcul de fonction dans le canal selon la revendication 7, dans lequel l'étape de décodage des superpositions des données d'entrée transmises et codées numériquement comprend l'extraction des combinaisons uniques pour les superpositions reçues des données d'entrée transmises et codées numériquement.

9. Procédé (100) de calcul de fonction dans le canal selon l'une quelconque des revendications précédentes, dans lequel les données d'entrée transmises et codées numériquement sont transmises sur des signaux ayant des puissances de transmission différentes.

10. Procédé (100) de calcul de fonction dans le canal selon l'une quelconque des revendications précédentes, dans lequel les données d'entrée transmises et codées numériquement depuis les unités numériques émettrices (501) sont transmises à une même fréquence porteuse et/ou dans lequel les données d'entrée transmises et codées numériquement depuis les unités numériques émettrices (501) sont transmises au même instant.

11. Procédé (100) de calcul de fonction dans le canal selon l'une quelconque des revendications précédentes, dans lequel le schéma de décodage est mis en œuvre dans une table de correspondance, LUT.

12. Procédé (100) de calcul de fonction dans le canal selon l'une quelconque des revendications précédentes, dans lequel l'étape de décodage des superpositions des données d'entrée transmises et codées numériquement comprend en outre une correction d'erreurs, et/ou une synchronisation, et/ou une acquisition d'informations d'état du canal.

13. Procédé (100) de calcul de fonction dans le canal selon l'une quelconque des revendications précédentes, dans lequel les données d'entrée sont des gradients et/ou des paramètres d'un modèle d'apprentissage automatique et/ou dans lequel la combinaison de données d'entrée est une moyenne fédérée de modèles d'apprentissage automatique.

14. Procédé (100) de calcul de fonction dans le canal selon l'une quelconque des revendications précédentes, dans lequel les données d'entrée codées numériquement provenant de la pluralité d'unités numériques émettrices (501) sont transmises de manière asynchrone et sont décodées sur la base d'une séquence temporelle unique de superpositions.

15. Système de communication numérique (500) comprenant une pluralité d'unités numériques émettrices (501) ; un ou plusieurs canaux (502) ; et au moins un récepteur numérique (503), les unités numériques émettrices (501) utilisant un ou plusieurs schémas de codage d'émission (201, 202) pour coder des données d'entrée et transmettre des données d'entrée codées numériquement, dans lequel les données d'entrée sont codées selon un schéma de modulation numérique, dans lequel le schéma de modulation numérique est un schéma de modulation basé sur l'amplitude et la phase, le ou les canaux (502) étant configurés pour obtenir des superpositions des données d'entrée transmises et codées numériquement, dans lequel le récepteur est configuré pour décoder lesdites superpositions en tant que combinaisons des données d'entrée transmises et codées numériquement, sur la base d'un schéma de décodage qui attribue à chacune des superpositions possibles une valeur prédéfinie correspondant à une combinaison prédéfinie des données d'entrée codées numériquement, dans lequel le récepteur est configuré pour décoder les superpositions en déterminant la phase et l'amplitude des données d'entrée transmises et codées numériquement, et en mettant en correspondance les signaux avec des combinaisons ou des fonctions prédéfinies des données d'entrée.

100

```
┌─────────────────────────────────────┐
│ Digitally encoding input data according to one or │ ⌐101
│ more transmitting encoding schemes   │
└─────────────────────────────────────┘
                    │
                    ▼
┌─────────────────────────────────────┐
│ Transmitting digitally encoded data from the │ ⌐102
│ transmitting digital units through the one or more │
│ channels                             │
└─────────────────────────────────────┘
                    │
                    ▼
┌─────────────────────────────────────┐
│ Obtaining superpositions of the digitally encoded │ ⌐103
│ data from the plurality of the transmitting digital │
│ devices                              │
└─────────────────────────────────────┘
                    │
                    ▼
┌─────────────────────────────────────┐
│ Based on a decoding scheme, which assigns, to │
│ any one of the possible superpositions of │
│ transmitted digital data, a predefined value │
│ corresponding to a predefined  combination of │ ⌐104
│ the digitally encoded input data, decoding the │
│ superpositions of the transmitted digital data, │
│ thereby obtaining combinations of the digitally │
│ encoded                              │
└─────────────────────────────────────┘
```

FIG. 1

FIG. 2

FIG. 3

400

log($q_1$)bits     log($q_2$)bits     log($q_K$)bits

$$
\begin{array}{cccc}
1000...0 & 1000...0 & \cdots & 1000...0 \\
0100...0 & 1000...0 & \cdots & 1000...0 \\
0010...0 & \vdots & \cdots & \vdots \\
\vdots & \vdots & \cdots & \vdots \\
000...01 & 1000...0 & \cdots & 1000...0 \\
100...00 & 0100...0 & \cdots & 100...0 \\
\vdots & \vdots & \cdots & \vdots \\
\vdots & \vdots & \ddots & \vdots \\
000...01 & 000...01 & \cdots & 000...01
\end{array}
\begin{bmatrix}
X_{1,1} \\
X_{1,2} \\
\vdots \\
X_{1,q1} \\
X_{2,1} \\
X_{2,2} \\
\vdots \\
X_{2,q2} \\
\vdots \\
X_{K,1} \\
X_{K,2} \\
\vdots \\
X_{K,qK}
\end{bmatrix}
=
\begin{bmatrix}
S_1 \\
S_2 \\
\vdots \\
S_k \\
\vdots \\
S_{KQ}
\end{bmatrix},
$$

A

401

X

402

g

403

FIG. 4

FIG. 5

600

| $X_1$ | $X_2$ | $X_1X_2$ | $\vec{X}_1 + \vec{X}_2$ |
|:---:|:---:|:---:|:---:|
| 0 | 0 | 0 | $\vec{0}$ |
| 0 | 1 | 0 | $\vec{1}$ |
| 0 | 2 | **0** | $\vec{2}$ |
| 1 | 0 | 0 | $\vec{1}$ |
| 1 | 1 | **1** | $\vec{2}$ |
| 1 | 2 | 2 | $\vec{3}$ |
| 2 | 0 | **0** | $\vec{2}$ |
| 2 | 1 | 2 | $\vec{3}$ |
| 2 | 2 | 4 | $\vec{4}$ |

FIG. 6

700

FIG. 7

800

| $x_1$ | $x_2$ | $x_1 x_2 + x_1$ | $x_1 + x_2$ |
|-------|-------|-----------------|-------------|
| 0 | 0 | 0 | $\vec{0}$ |
| 0 | 1 | **1** | $\vec{1}$ |
| 1 | 0 | **0** | $\vec{1}$ |
| 1 | 1 | 2 | $\vec{2}$ |

## FIG. 8

FIG. 9

FIG. 10

FIG. 11

FIG. 12

FIG. 13

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Over-the-Air Computing for 6G -- Turning Air into a Computer. **GUANGXU ZHU et al.** ARXIV.ORG. CORNELL UNIVERSITY LIBRARY, 04 September 2020

- Over-the-Air Computing for Wireless Data Aggregation in Massive IoT. **GUANGXU ZHU et al.** ARXIV.ORG. CORNELL UNIVERSITY LIBRARY, 14 November 2020